# EUROPEAN PATENT SPECIFICATION

(11) **EP 3 128 019 B1**
(45) Date of publication and mention of the grant of the patent: **14.10.2020**
(21) Application number: 15772250.5
(22) Date of filing: 30.03.2015
(51) Int. Cl.: C22C 9/00, C22C 9/02, C22C 9/04, C22C 9/06, C22F 1/08, C22F 1/00, H01B 1/02, H01L 23/00

(54) **COPPER ALLOY WIRE MATERIAL AND MANUFACTURING METHOD THEREOF**
DRAHTMATERIAL AUS KUPFERLEGIERUNG UND HERSTELLUNGSVERFAHREN DAFÜR
MATÉRIAU DE FIL D'ALLIAGE DE CUIVRE ET SON PROCÉDÉ DE FABRICATION

(30) Priority: 31.03.2014 JP 2014072611
(43) Date of publication of application: 08.02.2017
(73) Proprietor: Furukawa Electric Co. Ltd., Tokyo 100-8322 (JP)
(72) Inventor: TAKAZAWA, Tsukasa, Tokyo 100-8322 (JP)
(74) Representative: Forstmeyer, Dietmar
(86) International application number: PCT/JP2015/059965
(87) International publication number: WO 2015/152166

(56) References cited:
- WO-A1-2014/007258
- WO-A1-2014/007258
- WO-A1-2014/007259
- WO-A1-2014/007259
- WO-A1-2015/034071
- WO-A1-2015/034071
- CN-A- 102 851 527

## Description

### TECHNICAL FIELD

The present invention relates to a copper alloy wire and a method of producing the same, and more specifically the present invention relates to an extra-fine copper alloy wire for magnet wires and a method of producing the same.

### BACKGROUND ART

Along with the development in electronic equipment, making the size of an electronic part smaller is in progress, and there is an increasing demand for extra-fine copper alloy wire having a wire diameter of 0.1 mm or less. For example, a coil for micro speakers that is used in mobile phones, smart phones, and the like, is produced by working an extra-fine wire (a magnet wire) having a wire diameter of 0.1 mm or less by winding into a coil shape.

For this winding, toughness (elongation) is required as the workability capable of turn formation, and pure copper excellent in toughness has been conventionally used. However, pure copper is excellent in electrical conductivity but has low physical strength. In addition, there is a problem that pure copper is low in resistance to fatigue that is accompanied with coil vibration, and thus the service life of a coil is short. Further, there is a demand for further enhancement of coil formability in which coil-winding can be performed from a lengthy copper alloy wire. In particular, in the case of a small-sized coil or an angular (e.g. rectangular) shaped coil, since working conditions are more severe, higher coil formability and elongation are required. In the case where a wire having a fine wire diameter is worked into a coil form, high elongation is required. However, there is a dilemma that as the wire diameter becomes finer, it is more difficult to attain elongation.

In order to solve this problem, there is a proposal of a technique of using a high-concentration Cu-Ag alloy containing 2 to 15 mass% of Ag that can enhance the tensile strength almost without lowering the electrical conductivity, to achieve a balance between the elongation and the physical strength by controlling the working degree of the final working (Patent Literature 1). Further, in general, a metal or an alloy, which has been subjected to working, is enhanced in tensile strength and lowered in elongation. However, when this is subjected to heating at a certain temperature or higher, elongation is recovered again, while physical strength is lowered. Thus, there is a proposal of a technique of achieving a balance between physical strength and elongation even in a low-concentration alloy, by carrying out the heating at a temperature lower than or equal to the softening temperature (Patent Literature 2). However, this method is difficult to control the heating temperature and time period. In this regard, there is a proposal of a technique of performing a semi-softening treatment of achieving a balance between physical strength and elongation, by adding 0.05 to 0.2 mass% of Ag and 0.003 to 0.01 mass% of Zr into copper to widen the semi-softening temperature range (Patent Literature 3).

### CITATION LIST

### PATENT LITERATURES

Patent Literature 1: JP-A-2009-280860 ("JP-A" means unexamined published Japanese patent application)
Patent Literature 2: Japanese Patent No. 3941304
Patent Literature 3: JP-B-H04(1992)-77060 ("JP-B" means examined Japanese patent publication)

CN 102851527 discloses a contact wire for high-speed railway, which is a Cu-Ag-Mg wire comprising 0.20-0.40% Ag and 0.05-0.15% Mg.

WO 2014/007258 discloses a copper-alloy wire rod and a manufacturing method therefor, which copper-alloy wire comprises at least 0.5% Ag, at least 0.05% Mg, optionally 0.05-0.3% of Sn, Zr, Zn, In, Ni, Co, Zr and Cr, with the remainder consisting of copper and unavoidable impurities, and which can be used as a magnet wire.

WO 2014/007259 discloses a copper-alloy wire rod and a manufacturing method therefor, which copper-alloy wire contains, by mass, 0.5% to 4% silver and 0.05% to 0.3% of each of at least one element selected from the group consisting of tin, manganese, zinc, indium, nickel, cobalt, zirconium, and chromium, with the remainder comprising copper and unavoidable impurities, and which can be used as a magnet wire.

### SUMMARY OF INVENTION

### TECHNICAL PROBLEM

However, according to the demand for lengthening the service life of magnet wires and the demand for making magnet wires extremely finer (for example, a wire diameter of 0.07 mm or less), achievement of a balance between enhancement of elongation and further physical strength enhancement of copper alloy wires have been demanded. In addition to those, enhancement of coil-winding property and further enhancement of resistance to bending fatigue have been demanded. The resistance to bending fatigue is one of criteria for the service life of the coil.

The technique described in Patent Literature 1 relates to an alloy, which contains a high concentration of Ag up to 2 to 15%, and which is a high-cost material. In this regard, there is a demand for a technique by which sufficient physical strength and elongation can be exerted even in the case of a lower-concentration Cu-Ag alloy or a copper alloy not containing Ag. Further, as described in Patent Literature 1, when the Ag content is increased in order to further increase the physical strength, rather, electrical conductivity is lowered. Further, Ag is an element, which enhances heat resistance, and makes it difficult to perform heating. Further, when working is performed until wires become extra-fine wires, characteristics may not be sufficiently exhibited only by controlling the degree of the final working in some cases.

The highly electrical-conductive copper alloy of a general solid solution-type as described in Patent Literature 2, has a narrow temperature range for realizing a semi-softening heating. Thus, it is difficult to realize stabilized performance. Further, it is difficult to achieve further enhancement in physical strength and further enhancement of resistance to bending fatigue, while securing electrical conductivity and elongation, by using a copper alloy described in Patent Literature 2. Further, since the elongation of a wire obtainable by a semi-softening heating is lower than the elongation of a wire obtainable by a softening treatment, the formability of the wire obtainable by the semi-softening heating is insufficient for coil-winding under more severe conditions.

Further, the method of performing a semi-softening treatment by adding a trace amount of Zr to a low-concentration Cu-Ag alloy (Patent Literature 3) can readily achieve a balance between elongation and physical strength. However, in the similar manner as in Patent Literature 2, the method in the Patent Literature 3 is insufficient in view of elongation enhancement. Further, recently, the shape of magnet wires is not limited to round wires, and investigations have also been conducted on the employment of square wires and rectangular wires. Even in the cases of these square wires and rectangular wires, it is requested to employ a wire with a thickness that is thin to the extent of that corresponding to the wire diameter of the round wire.

The present invention was achieved in view of those problems in those conventional art, and it is an object of the present invention to provide, at low cost, a copper alloy wire that has high in elongation and that is excellent in workability, i.e. coil formability, and in addition to those, that is also excellent in coil characteristics (service life of the coil), which is obtained by using the copper alloy wire, and that is used, for example, in magnet wires.

### SOLUTION TO PROBLEM

The inventor of the present invention conducted thorough investigations on various copper alloys and the production method therefor, in order to develop a copper alloy wire that has high in elongation and that is excellent in coil formability, and in addition to those, that is also excellent in coil characteristics (service life of the coil), which is obtained by using the copper alloy wire. As a result, the inventor has found that when the recrystallized texture of the copper alloy wire is properly controlled, a high elongation and excellent in coil formability, and thus a copper alloy wire that is also excellent in its coil characteristics (service life of the coil) is obtained. The present invention was completed based on those findings.

That is, the present invention provides the subject-matter according to the attached claims, including the following means:
(1) A copper alloy wire consisting of at least one selected from the group consisting of:
   [1] 0.1 to 4 mass% of Ag; and
   [2] at least one selected from the group consisting of Sn, Mg, Zn, In, Ni, Co, Zr and Cr each at a content of 0.05 to 0.30 mass%,
      with the balance being Cu and unavoidable impurities,
      wherein
      the copper alloy wire has a recrystallized texture, a tensile strength of 260 MPa or more, and an elongation of 30% or more;
      the wire diameter or wire thickness is 0.1 mm or less and 0.01 mm or more;
      the area ratio of grains having <101> orientation, when a cross-section perpendicular to the longitudinal direction of the wire is observed by EBSD in a direction normal to the cross-section, is 10% or more of the entire measurement area, , wherein
      the area ratio of the grains having <101> orientation is obtained by an EBSD method in such a manner that the cross-section perpendicular to the longitudinal direction (transverse cross-section) of a copper alloy wire sample is scanned at a step of 0.02 µm; the orientation of each grain is observed and analyzed; based on the analyzed results, a plane in which a deviation angle with the <101> orientation is within ±10 degrees is defined as a <101> plane; a grain which has a plane in which a deviation angle with the <101> orientation is within ±10 degrees when the cross-section perpendicular to the longitudinal direction of the wire is observed by EBSD in a direction normal to the cross-section, is defined as a grain having the <101> orientation; the area ratio (%) of grains having the <101> orientation with respect to the entire measurement area is calculated based on the measurement results.
(2) The copper alloy wire according to (1), wherein the area ratio of the grains having <101> orientation is 20% or more of the entire measurement area.
(3) The copper alloy wire according to (1) or (2), wherein the average grain size of the matrix is 0.2 to 5.0 µm.
(4) A method of producing the copper alloy wire according to any one of (1) to (3), the method including the steps of:
   melting and casting a copper alloy material giving an alloy composition, which consists of at least one selected from the group consisting of:
      [1] 0.1 to 4.0 mass% of Ag, and
      [2] at least one selected from the group consisting of Sn, Mg, Zn, In, Ni, Co, Zr and Cr each at a content of 0.05 to 0.30 mass%,
   with the balance being Cu and unavoidable impurities, to thereby obtain a roughly-drawn rod;
   repeating cold-working in which a working degree η in each cold-working step is 0.5 or more but 4 or less and intermediate annealing each at least one time in this order on the roughly-drawn rod, to obtain a wire having a predetermined wire diameter; and then
   performing final cold-working in which a working degree η is 0.5 or more but 4 or less and final-annealing on the wire in this order,
   in which, when a batch-type intermediate annealing or a batch-type final-annealing is performed, heating is performed at: (i) 300 to 800°C; or (ii) 400 to 800°C when Ag or Zr is contained as an element; but each equal to or higher than the recrystallizing temperature of the copper alloy material, for 30 minutes to 2 hours under an inert gas atmosphere; or
   when a continuous-type intermediate annealing or a continuous-type final-annealing is performed, heating is performed at: (i) 400 to 850°C; or (ii) 500 to 850°C when Ag or Zr is contained as an element; but each equal to or higher than the recrystallizing temperature of the copper alloy material, for 0.1 to 5 seconds under an inert gas atmosphere.

In the present invention, a wire means to include a square wire or a rectangular wire, in addition to a round wire. Thus, unless otherwise specified, the wire of the present invention collectively means a round wire, a square wire, and a rectangular wire. Herein, the size of the wire means, in the case of a round wire (the cross-section perpendicular to a wire-drawing direction is circular), the wire diameter φ (the diameter of the circle of the cross-section) of the round wire; in the case of a square wire (the cross-section perpendicular to a wire-drawing direction is square), the thickness t and the width w (each being the length of one side of the square of the cross-section and being identical to each other) of the square wire; and in the case of a rectangular wire (the cross-section perpendicular to a wire-drawing direction is rectangular), the thickness t (the length of a shorter side of the rectangle of the cross-section) and the width w (the length of a longer side of the rectangle of the cross-section) of the rectangular wire.

### ADVANTAGEOUS EFFECTS OF INVENTION

According to the present invention, it is possible to obtain a copper alloy wire that is excellent in a balance between given physical strength necessary for coil formation and favorable elongation necessary for coil formation and that is also excellent in characteristics of a coil obtained by using the copper alloy wire (specifically, the service life of a coil represented by resistance to bending fatigue and coil formability in which a lengthy copper alloy wire can be formed into the coil with less defects). The copper alloy wire of the present invention can be preferably used, for example, for a magnet wire or the like. In addition, according to the method of producing a copper alloy wire of the present invention, it is possible to produce the copper alloy wire at low cost stably.

Other and further features and advantages of the invention will appear more fully from the following description, appropriately referring to the accompanying drawings.

### BRIEF DESCRIPTION OF DRAWINGS

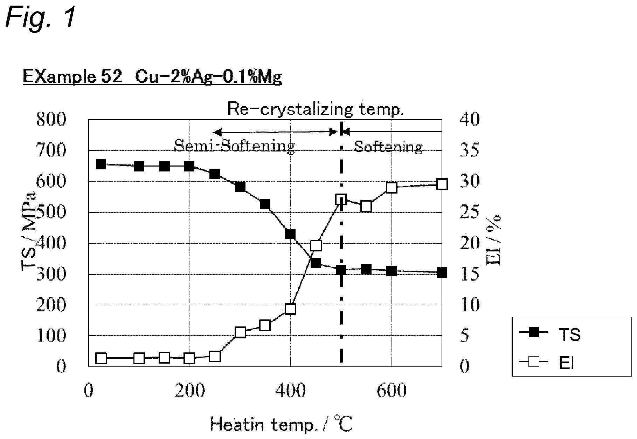

{Fig. 1}
   Fig. 1 is a schematic diagram illustrating the changes in the physical strength and elongation of a copper alloy wire with respect to the change in the heating temperature. Fig. 1 discloses an example for the copper alloy composition of Example 52.
{Fig. 2}
   Fig. 2 is a front view schematically showing the apparatus used in the test for measuring the number of repeating times at breakage in bending fatigue (the number of repeating times at breakage), which was conducted in the Examples.

### MODE FOR CARRYING OUT THE INVENTION

The present invention will be described in detail below.

### [Alloy composition]

The copper alloy wire of the present invention contains [1] Ag at a content of 0.1 to 4 mass% alone, or [2] at least one selected from the group consisting of Sn, Mg, Zn, In, Ni, Co, Zr, and Cr each at a content of 0.05 to 0.30 mass%, with the balance being Cu and unavoidable impurities. Herein, when the content of an alloy additive element is simply expressed in "percent (%)", this means "mass%". Further, there are no particular limitations on the total content of at least one alloy component selected from the group consisting of Sn, Mg, Zn, In, Ni, Co, Zr, and Cr, but in order to prevent a noticeable lowering in the electrical conductivity of the copper alloy wire, the total content of at least one alloy component selected from the group consisting of Sn, Mg, Zn, In, Ni, Co, Zr, and Cr, other than Ag, is preferably 0.50 mass% or less, more preferably 0.05 to 0.30 mass%.

These elements each are a solid-solution strengthening-type or precipitation strengthening-type element, and when any of these elements is/are added to Cu, physical strength can be enhanced without lowering the electrical conductivity to a large extent.

As a result of this addition, the physical strength of the copper alloy wire itself is enhanced, and the resistance to bending fatigue is enhanced. Although the resistance to bending fatigue is generally proportional to tensile strength, if further working is applied in order to enhance the tensile strength, elongation is lowered, and the wire cannot be formed into an extra-fine copper alloy wire, such as a magnet wire. Herein, the bending strain exerted on the copper alloy wire at the time of bending fatigue increases toward the outer circumference of the wire, and the amount of bending strain decreases as the center is approached. According to the present invention, the entirety of the wire maintains a softened state. Thus, since elongation of the wire as a whole can be sufficiently secured, forming into an extra-fine copper alloy wire, such as a magnet wire, is enabled.

Among these elements, Ag is an element that can particularly enhance physical strength without lowering electrical conductivity, and a Cu-Ag-based alloy is preferably used as a copper alloy according to the present invention that is used, for example, in a magnet wire or the like. Ag is an exemplary essential additive element for the copper alloy according to the present invention. In the present invention, the Ag content is set to 0.1 to 4.0%, preferably 0.5 to 2.0%. If the content of Ag is too small, sufficient physical strength cannot be obtained. Further, if the Ag content is too large, electrical conductivity is lowered, and also it becomes excessively high cost.

In the case where the Ag content is smaller than 0.1 mass%, Ag is regarded as an unavoidable impurity.

The at least one element selected from the group consisting of Sn, Mg, Zn, In, Ni, Co, Zr, and Cr is an another example of an essential alloying element in the copper alloy according to the present invention. In the present invention, the contents of those elements are, respectively, preferably 0.05 to 0.30%, and more preferably 0.05 % to 0.20%. If this content is too small as the respective content, the effect of strength enhancement owing to the addition of any of these elements cannot be expected in most cases. Further, if this content is too large, since the lowering of the electrical conductivity is too large, the resultant copper alloy is inappropriate as a copper alloy wire, such as a magnet wire.

In the case where the content of at least one element selected from the group consisting of Sn, Mg, Zn, In, Ni, Co, Zr, and Cr is smaller than 0.05 mass%, any of those each is regarded as an unavoidable impurity.

### [Crystal orientation]

The copper alloy wire of the present invention is characterized in that the <101> texture is 10% or more of the entire wire. It is preferable that the <101> texture is 20% or more of the entire wire. Herein, when the <101> texture is 10% or more of the entire wire, it is implied that when a cross-section perpendicular to the longitudinal direction (wire-drawing direction) of the wire is observed by EBSD in a direction normal to the cross-section, the area ratio of grains having the <101> orientation is 10% or more of the entire measurement area. When the copper wire is subjected to drawing and heating in a usual manner, the <100> texture and the <111> texture are developed. However, as a result of the investigation of the inventor of the present invention on extra-fine copper alloy wires having various textures, the inventor has found that a copper alloy wire in which the <101> texture is occupied at 10% or more of the entire wire, exhibits the characteristics, which is excellent in elongation, and which is also excellent in coil formability. In addition, when the <101> texture is too large, the physical strength may lower, and thus the <101> texture is preferably 40% or less of the entire wire.

### [EBSD method]

The observation and analysis of the crystal orientation in the present invention are conducted using the EBSD method. The EBSD, which stands for electron backscatter diffraction, is a technique of crystal orientation analysis using reflected electron Kikuchi-line diffraction that occurs when a sample is irradiated with an electron beam under a scanning electron microscope (SEM).

In the EBSD measurement in the present invention, the cross-section perpendicularly to the longitudinal direction (transverse cross-section) of the wire is scanned at 0.02 µm step, and then the orientation of each grain is analyzed. Based on the analyzed results, a plane in which a deviation angle with the <101> orientation is within ±10 degrees is defined as a <101> plane, and a grain which has a plane in which a deviation angle with the <101> orientation is within ±10 degrees when the cross-section perpendicularly to the longitudinal direction of the wire is observed from the direction normal to the cross-section by the EBSD method, is defined as a grain having the <101> orientation. Then, it is to determine the ratio of the area of grains having the <101> orientation to the entire measurement area, i.e. the area ratio (%) of grains having the <101> orientation to the entire measurement area, when the cross-section perpendicularly to the longitudinal direction of the wire is observed from the direction normal to the cross-section by the EBSD method. The scan step may be appropriately determined depending on the size of the grain of a sample. The analysis of grains after measurement can be conducted by using, for example, an analysis software OIM software (trade name) produced by TSL solutions Co., Ltd. Information obtained by analysis of the grains by the EBSD measurement includes information on a portion up to a depth of several 10 nm in which an electron beam enters the sample. However, since the information is sufficiently small with respect to the largeness of the area, which is being measured, in the specification, the information is considered as area ratio of grains. Further, since the area of the grains varies depending on the longitudinal direction (LD) of the wire, it is preferable to obtain an average by taking arbitrary points in the longitudinal direction.

### [Average grain size of matrix of copper alloy wire]

In order to further enhance characteristics in the present invention, the average grain size is preferably 0.2 to 5.0 µm. When the average grain size is too small, the grain is excessively fine, and thus work-hardening performance may be lowered and the elongation may be slightly lowered in some cases. On the other hand, when the average grain size is too large, non-uniform deformation may readily occur and, of course, the elongation may be lowered in some cases.

### [Production method]

The production method of the copper wire of the present invention will be described.

As discussed above, the shape of the copper alloy wire of the present invention is not limited to a round wire, and may also be a square wire or a rectangular wire. Then, these will be described below. The copper alloy wire of the present invention is not a work-finished material but an anneal-finished material.

### [Production method of a round wire]

First, the production method of a copper alloy round wire of the present invention includes, for example, the steps of: casting; cold-working (specifically, cold wire-drawing, and also referred to as intermediate cold-working); intermediate annealing; final cold-working; and final-annealing. Herein, the cold-working and the intermediate annealing may be performed in this order if necessary, or these steps may be repeated in this order two times or more. The number of repeating times of the cold-working and the intermediate annealing is not particularly limited, but is generally one to five times, and preferably two to four times. In a case where the size of the cast ingot and the final wire diameter are close to each other (for example, the working degree from the cast ingot to the final wire diameter is in the range of 0.5 to 4, that is, the size of the cast ingot is small or the final wire diameter is thick), it is not necessary to perform the intermediate annealing, and the intermediate annealing can be omitted. In this case, the cold-working as the intermediate wire-drawing after the intermediate annealing is also omitted.

### [Casting]

Cu and/or any of additive elements of Ag, Sn, Mg, Zn, In, Ni, Co, Zr, and Cr are/is melted and cast in a crucible. The atmosphere inside the crucible at the time of melting is preferably selected to be a vacuum or an inert gas atmosphere, such as nitrogen or argon, in order to prevent occurrence of oxides. There are no particular limitations on the casting method, and use may be made of such a continuous casting wire-drawing method, for example, a transverse continuous casting machine or an upcast method. By means of the continuous casting wire-drawing method, steps can be carried out continuously from casting to wire-drawing, and a roughly-drawn rod is obtained with a diameter of generally about φ 8 to 23 mm. On the other hand, in the case where no continuous casting wire-drawing method is utilized, a roughly-drawn rod having a diameter of about φ 8 to 23 mm is similarly obtained, by subjecting the billet (cast ingot) obtained by casting, to wire-drawing.

### [Cold-working, intermediate annealing]

The cold-working and heating (intermediate annealing) may be repeatedly performed, if necessary, on this roughly-drawn rod each at least one time in this order. When this roughly-drawn rod is subjected to cold-working and heating (intermediate annealing), the roughly-drawn rod is worked into a fine-diameter wire having a diameter of generally about φ 0.06 to 1 mm.

The working degree and the working rate in each cold-working will be described.

Each cold-working is performed such that a wire (a fine-diameter wire) in which a working degree (η) is within the range of 0.5 or more but 4 or less can be obtained. Herein, the working degree (η) is defined as η = In(S₀/S₁), when the cross-sectional area of the wire (or rod) before working is designated as S₀, and the cross-sectional area of the wire (or rod) after working is designated as S₁. When the working degree is too small, the physical strength and the elongation are not sufficiently exhibited due to the heating (intermediate annealing) after working, and the number of steps increases. Thus, since the energy consumption amount increases, the production efficiency is poor, which is not preferable. In addition, when the working degree is too large, the orientation property of the <101> texture (the area ratio of the grains having <101> orientation) becomes small to be less than 10%, and instead, thus the <111> texture increases. Thus, the texture after the finish-annealing (final-annealing) is also affected and the elongation is lowered.

Herein, each cold-working may be performed at a plurality of times of cold-working passes. The number of passes of cold-working between two subsequent steps of heating (intermediate annealing) is not particularly limited, and is generally two to 40 times.

In the producing method described in Patent Literature 1, only the working degree in the working before the final heating is controlled. To the contrary, in the producing method of the present invention, when all of the working degrees in each intermediate cold-wire-drawing (intermediate cold-working) and finish cold-wire-drawing (final cold-working) as the cold-working between each of two heating steps are appropriately controlled, the orientation property of the recrystallized texture can be properly controlled. Thus, it is possible to obtain a copper alloy wire, in which a balance between the physical strength and the elongation is good and is at a high level, and which is also excellent in coil characteristics.

After each cold-working, if necessary, the intermediate annealing is performed. As described above, when the size of the cast ingot is close to the final wire diameter, the intermediate annealing may be omitted. The specific heating temperature may vary depending on the alloy composition, but it is necessary to perform the intermediate annealing at a temperature equal to or higher than the recrystallizing temperature. In a copper alloy wire, there are roughly two kinds of crystal texture states. One of them is a worked texture. This is a texture state in which many strains have been introduced into the crystals as a result of wire-drawing or the like. The other one is a recrystallized texture. This is a texture state having a small variation in the grain size and relatively fewer strains.

When intermediate annealing is applied at a certain amount of heat, a worked texture of a copper alloy wire is converted to a recrystallized texture. In the present invention, the temperature at which almost all of the metal texture is converted to the recrystallized texture is defined as "recrystallizing temperature". Then, a heating (temperature and time period) by which almost all of the metal texture is converted to the recrystallized texture is referred to as a softening treatment. The temperature and time period for the softening treatment change depending on the composition, working degree, thermal history and the like of the copper alloy wire. In particular, it is known that a copper alloy wire containing Ag or Zr added has a high recrystallizing temperature. As the working degree is higher, a softening treatment can also be carried out at a lower temperature. Further, as the heating time period that has already been elapsed is longer, a softening treatment can be carried out even at a lower temperature. When the temperature for the softening treatment is raised, recrystallization further proceeds, and elongation of the copper alloy wire is restored, while physical strength is lowered. However, generally, restoration of elongation and lowering in physical strength meet an inflection point at the recrystallizing temperature. In view of material characteristics, a heating at a temperature equal to or higher than this inflection point is referred to as a softening treatment. In other words, generally, in a heating carried out up to the vicinity of the recrystallizing temperature but at a temperature below the recrystallizing temperature, the change in elongation and physical strength with respect to the change in the heating temperature is large. On the contrary, in a heating at a temperature equal to or higher than the recrystallizing temperature, the change in elongation and physical strength with respect to the change in the heating temperature is small.

When a heating is applied at a temperature equal to or higher than the recrystallizing temperature, the texture is rearranged into a recrystallized texture. Thus, in order to disappear strains, physical strength is lowered, and elongation is enhanced (restored). However, even if a heating is applied at a temperature lower than the recrystallizing temperature, restoration (rearrangement of dislocations) or partial recrystallization occurs, and restoration of elongation and lowering in physical strength begin to occur. In the present invention, a heating that is carried out for a predetermined time period in a temperature range from this temperature at which restoration of elongation and lowering in physical strength begin to occur (a temperature higher than about 200°C in the example illustrated in Fig. 1) to a temperature blow the recrystallizing temperature (below 500°C), is referred to as a semi-softening treatment. Since the heating is carried out at a temperature below the recrystallizing temperature, the texture in a semi-softened state becomes a texture in which a work-finished texture and a recrystallized texture are co-present in mixture. The temperature range for the semi-softening heating also varies with the alloy composition, amount of deformation, thermal history and the like, in the similar manner as the softening treatment.

As a reference, the relations among the annealing temperature, the physical strength and the elongation in the copper alloy composition of Example 52, is shown in Fig. 1. In this example, the recrystallizing temperature, that is, the softening temperature is 500°C. As such, a softening treatment and a semi-softening treatment are distinguished, as treatments imparting different physical property to a copper alloy wire. The intermediate annealing for the method of producing a copper alloy wire of the present invention corresponds to a "softening treatment". Therefore, the heating temperature is set to a temperature equal to or higher than the recrystallizing temperature.

The heating method of performing the intermediate annealing may be roughly classified into a batch-type method and a continuous method.

Since the batch-type heating requires a long treatment time and a larger cost, this method is poor in productivity. However, since it is easy to perform the control of temperature or retention time period, it is easy to perform the control of characteristics. To the contrary, since heating and the wire-drawing can be continuously carried out in the continuous-type heating, continuous-type heating is excellent in productivity. However, since it is necessary to perform heating in the continuous-type heating in a very short time period, it is necessary to control the heating temperature and time period precisely, to realize characteristics stably. These heating methods have advantages and disadvantages as described above, and thus, it is desirable to select the heating method according to the purpose. In general, as the heating temperature becomes higher, heating is performed in a short time period, and as the heating temperature becomes lower, heating is performed in a long time period.

In a case where a batch-type intermediate annealing is performed, for example, heating is performed in a heating furnace in an inert gas atmosphere, such as nitrogen or argon, at 300 to 800°C for 30 minutes to 2 hours. In particular, in a case where an element enhancing heat resistance, such as Ag or Zr, is added, heating is preferably performed at 400 to 800°C for 30 minutes to 2 hours. As described above, specific heating temperature varies depending on the alloy composition, but the intermediate annealing temperature is at a temperature equal to or higher than the recrystallizing temperature. Hereinafter, the batch-type intermediate annealing is also abbreviated as the batch annealing.

On the other hand, examples of the continuous-type heating include electrically heating-type heating and in-atmosphere running-type heating.

First, the electrically heating-type heating is a method of: providing electrode rings in the mid course of the wire-drawing step; applying an electric current to flow through the copper alloy wire passing among the electrode rings; and performing heating by the Joule heat generated by the copper alloy wire itself.

Then, the in-atmosphere running-type heating is a method of: providing a vessel for heating in the mid course of wire-drawing; and performing heating by passing a copper alloy wire in the atmosphere of the vessel for heating that has been heated to a predetermined temperature.

For both of those heating methods, it is preferable to perform heating in an inert gas atmosphere, in order to prevent oxidation of the copper alloy wire.

Regarding the heating conditions in the case of performing a continuous-type intermediate annealing, heating is preferably performed at 400 to 850°C for 0.1 to 5 seconds. In particular, in a case where an element enhancing heat resistance, such as Ag or Zr, is added, heating is preferably performed at 500 to 850°C for 0.1 to 5 seconds. As described above, specific heating temperature varies depending on the alloy composition, but the intermediate annealing temperature is at a temperature equal to or higher than the recrystallizing temperature.

Hereinafter, the intermediate annealing to be conducted by any of the two types of continuous-type annealing of the electrically heating-type heating and the in-atmosphere running-type heating are abbreviated as electric current annealing and running annealing, respectively. The intermediate annealing performed by any one of heating types is carried out in a manner that insufficient heating is performed, the sufficient removal of strain and recrystallization cannot be carried out, and thus a worked texture of <111> remains. Thus, sufficient elongation cannot be exhibited in the thus-obtained final product.

### [Finish cold-working (final cold-working)]

If necessary, the wire, which has been subjected to the cold-working and the intermediate annealing, is subjected to finish cold-working, to have a desired wire diameter. This finish cold-working is also performed in the range in which the working degree (η) of the copper alloy wire is 0.5 or more but 4 or less, similarly to the intermediate cold-working. When the working degree is too small, working is not sufficiently performed, and thus the work-hardening to the copper alloy wire is not sufficient. Further, the physical strength of the copper alloy wire to be obtained after the finish-annealing (final annealing) is not sufficient. On the other hand, when the working degree is too large, it is not possible to obtain 10% or more of the <101> texture after the finish-annealing, and sufficient elongation cannot be obtained. Preferably, the finish cold-working is performed in the range in which the working degree is 0.5 or more but 3 or less, more preferably, the finish cold-working is performed in the range in which the working degree (η) is 0.5 or more but 2 or less. When the finish cold-working is performed at this preferable working degree, the <101> texture becomes 10% or more, and it is possible to obtain a more excellent copper alloy wire having an elongation of 25% or more.

### [Finish-annealing (final-annealing)]

The copper alloy wire that has been wire-drawn to a desired size (wire diameter) by the step of the finish cold-working (final cold-working), is subjected to finish-annealing at a temperature equal to or higher than the recrystallizing temperature as the final-heating. This heating also corresponds to the softening treatment. In the case of performing a batch-type finish-annealing, heating is performed at 300 to 800°C for 30 minutes to 2 hours. On the other hand, in the case of performing a continuous-type finish-annealing, heating is performed at 400 to 850°C for 0.1 to 5 seconds. In particular, in a case where an element enhancing heat resistance, such as Ag or Zr, is added, heating is performed at 400 to 800°C for 30 minutes to 2 hours in the case of the batch-type. On the other hand, in the case of the continuous-type, it is to perform heating at 500 to 850°C for 0.1 to 5 seconds. As described above, specific heating temperature varies depending on the alloy composition, but the finish-annealing temperature is at a temperature equal to or higher than the recrystallizing temperature.

Hereinafter, the batch-type finish-annealing is also abbreviated as the batch annealing. In addition, the two types of continuous-type finish-annealing are also abbreviated as electric current annealing and running annealing, respectively.

The finish-annealing heating is preferably performed at a temperature ranging from the recrystallizing temperature to (the recrystallizing temperature + 200°C), more preferably a temperature ranging from the recrystallizing temperature to (the recrystallizing temperature + 100°C), and further preferably a temperature ranging from the recrystallizing temperature to (the recrystallizing temperature + 50°C). If the temperature of the final heating (final annealing) is too high, physical strength is lowered. Further, when the heating is performed at a temperature higher than (the recrystallizing temperature + 200°C), grains are made coarsened so that elongation is lowered.

### [Production method of a rectangular wire]

Next, the production method of a copper alloy rectangular wire of the present invention will be described. The method of producing a copper alloy rectangular wire of the present invention is the same as the method of producing a round wire described above, except for containing rectangular wire-working. Specifically, the method of producing a copper alloy rectangular wire of the present invention is carried out by performing the steps, for example, of: casting; cold-working (cold wire-drawing); rectangular wire-working; and final-heating (final-annealing), in this order. It is also the same as the method of producing a round wire that the intermediate annealing (intermediate heating) may be carried out in the mid course of the cold-working and the rectangular wire-working, if necessary. The conditions of the steps of working and heating, such as casting, cold-working, intermediate annealing, and final-annealing, the preferred conditions thereof, and the number of repeating times of cold-working and intermediate annealing are the same as those for the method of producing a round wire.

### [Rectangular wire-working]

Up to the steps before the rectangular wire-working, the production process is the same as that for the round wire, in which an ingot obtained by casting is subjected to cold-working (wire-drawing) to obtain a roughly-drawn rod having a round wire shape, and the roughly-drawn rod is further subjected to intermediate annealing if necessary. Regarding the rectangular wire-working, the round wire (roughly-drawn rod) thus obtained is subjected to cold-rolling using a rolling machine, cold-rolling using a cassette roller die, pressing, drawing, and the like. Through this rectangular wire-working, the transverse direction (TD) cross-section shape is worked into a rectangular shape, to obtain the shape of a rectangular wire. This rolling and the like are generally carried out in one to five passes. The reduction ratio in each pass and the total reduction ratio at the time of rolling and the like are not particularly limited, and may be appropriately set to obtain a desired rectangular wire size. Herein, the reduction ratio is the ratio of change in the thickness in the rolling direction upon performing the rectangular wire-working, and when the thickness before rolling is designated as t₁, and the thickness of the wire after rolling is designated as t₂, the reduction ratio (%) is represented by: {1 - (t₂/t₁)} × 100. Further, in the present invention, the working degree η in the rectangular wire-working is defined as η = In(t₁/t₂). For example, this total reduction ratio can be adjusted to 10 to 90%, and the reduction ratio in each pass can be adjusted to 10 to 50%. Herein, in the present invention, there are no particular limitations on the cross-section shape of the rectangular wire, but the aspect ratio is generally 1 to 50, preferably 1 to 20, and more preferably 2 to 10. The aspect ratio (represented by w/t as described below) is the ratio of a shorter side to a longer side in the rectangle that forms the transverse direction (TD) cross-section (that is, the cross-section perpendicular to the longitudinal direction) of a rectangular wire. In regard to the size of the rectangular wire, a rectangular wire thickness t is equal to the shorter side of the rectangle that forms the transverse direction (TD) cross-section, and a rectangular wire width w is equal to the longer side of the rectangle that forms the transverse direction (TD) cross-section. The rectangular wire thickness t is generally 0.1 mm or less, preferably 0.07 mm or less, and more preferably 0.05 mm or less. The rectangular wire width w is generally 1 mm or less, preferably 0.7 mm or less, and more preferably 0.5 mm or less.

When this rectangular wire is subjected to coil-working (winding) in the thickness direction, high tensile strength, elongation and electrical conductivity can be exhibited, similarly to the round wire according to the present invention. Herein, subjecting a rectangular wire to coil-working in the thickness direction means that a rectangular wire is wound into a coil shape while taking the width w of the rectangular wire as the width of the coil.

### [Production method of a square wire]

Further, in the case of producing a square wire, it is enough to set the transverse direction (TD) cross-section to be a square (w = t), in the method of producing a rectangular wire.

### [Other embodiments of the production methods of a rectangular wire and a square wire]

Instead of the production methods described above, a sheet or strip having a predetermined alloy composition is produced, and the sheet or strip is slit, to obtain a rectangular wire or square wire having a desired wire width.

This production process, for example, contains: casting; hot-rolling; cold-rolling; finish-annealing; and slitting. If necessary, the intermediate annealing may be carried out in the mid course of a plurality of cold-rollings. Slitting may be carried out before the finish-annealing, if necessary.

### [Physical properties]

According to the producing method of the present invention described above, a copper alloy wire having an area ratio of the <101> texture of 10% or more, preferably 20% or more (generally, 40% or less), of the entire wire (i.e. the entire measurement area), can be obtained. The copper alloy wire of the present invention has a tensile strength of 260 MPa or more, more preferably a tensile strength of 300 MPa or more. When the tensile strength is too small, the physical strength is insufficient when the diameter is made finer, and the wire may be poor in resistance to bending fatigue in some cases. The upper limit value of the tensile strength is not to be particularly limited, but generally 400 MPa or less. Further, the copper alloy wire of the present invention has an elongation (tensile elongation at breakage) of 30% or more. When the elongation is too small, defects, such as breakage, may occur at the time of forming into a coil in some cases. The upper limit value of the elongation is not to be particularly limited, but generally 40% or less.

The copper alloy wire of the present invention has an electrical conductivity of preferably 70%IACS or more, more preferably 80%IACS or more, and further preferably 90%IACS or more. Since energy loss is small in the case of having a higher electrical conductivity, the copper alloy wire is preferable as, for example, a magnet wire. The copper alloy wire as a magnet wire needs to have an electrical conductivity of 70%IACS or more, preferably 80%IACS or more, and further preferably 90%IACS or more. The upper limit value of the electrical conductivity is not to be particularly limited, but generally 100%IACS or less.

The copper alloy wire of the present invention, preferably, has such a high elongation that the copper alloy wire can be formed into as an extra-fine magnet wire, as well as the copper alloy wire of the present invention exhibits high in resistance to bending fatigue. Further, the copper alloy wire of the present invention is also preferably excellent in coil characteristics (service life of the coil, and coil formability). Further, the copper alloy wire of the present invention preferably is high in electrical conductivity.

### [Wire diameter or wire thickness, use]

The wire diameter or the wire thickness is 0.1 mm or less, more preferably 0.07 mm or less, and further preferably 0.05 mm or less. At the current level of technique, the lower limit value of the wire diameter or the wire thickness is 0.01 mm or more.

The use of the copper alloy wire of the present invention is not particularly limited. Examples of the use include an extra-fine magnet wire for use in speaker coils that are used in mobile phones, smart phones, and the like.

### EXAMPLES

The present invention will be described in more detail based on examples given below, but the invention is not meant to be limited by these.

### [Examples and Comparative examples of round wires]

With respect to the cast material, the copper alloy raw materials in Examples according to this invention and Comparative examples having the respective alloy composition, as shown in Tables 1-1, 2-1, 2-6, 2-11, and 4-1, each containing Ag at a content of 0.1 to 4 mass%, and/or at least one selected from the group consisting of Sn, Mg, Zn, In, Ni, Co, Zr, and Cr each at a content of 0.05 to 0.3 mass%, with the balance being Cu and unavoidable impurities, were cast into ingots (roughly-drawn rods) with diameters ϕ 8 to 22 mm, respectively, by a transverse-type continuous casting method.

The cold-working (intermediate cold-wire-drawing), the intermediate annealing (intermediate heating), the final cold-working (finish cold-wire-drawing), and the final-annealing (finish heating) were carried out on those roughly-drawn rods in this order, thereby for preparing each round wire sample (test material) having wire diameters as shown in each Table.

The heating of the intermediate annealing and the final-annealing were carried out by any manner selected from three patterns of batch annealing, electric current annealing, and running annealing, each under a nitrogen atmosphere. In each Table, the types of the performed heating were presented as "batch," "electric," and "running." The heating temperature and the heating time period of the heating were presented in each column. The intermediate annealing and the final-annealing were presented in the performing order as Heating 1 → Heating 2 → Heating 3 → .... "X" in "Heating X" indicates the performing order (the number of the performing) of the annealing (X-th). Of them, the heating performed finally is the final-annealing. In the test examples presented in each Table, there are cases where the intermediate annealing was performed once to four times and where the intermediate annealing was not performed at all. The value presented in the column of "Wire diameter" in the item of "Heating X" in each test example is the wire diameter of the wire after the cold-working (intermediate cold-working or final cold-working) immediately before performing the X-th heating. The working degree in the cold-working (intermediate cold-working or final cold-working) was presented in the column of "Working degree."

In Tables 1-2, 2-4, 2-9, and 2-14, the working degree in the cold-working (final cold-working) performed finally was presented in the column of "Working degree in final working."

### [Examples and Comparative examples of rectangular wires]

Using the copper alloys of the Examples according to the present invention and Comparative examples, each having the respective alloy composition shown in Table 3-1, a rectangular wire sample was prepared in the same manner as in the round wire, except that after the roughly-drawn rod obtained by cold-working (wire-drawing) the cast ingot was subjected to the intermediate annealing (Heating 1 in the table), the cold-working (wire-drawing) and the intermediate annealing (Heating 2 → Heating 3 → Heating 4 in the table) were performed each at least once, and then the finish-annealing (any of Heating 3, Heating 4, and Heating 5 in the table) was performed after performing the rectangular wire-working.

Regarding the rectangular wire-working, as shown in Table 3-3 to 3-4, a round wire before this rectangular wire-working was worked by cold-rolling into a rectangular wire such that the wire diameter ϕ (mm) was worked into a size of thickness t (mm) × width w (mm).

In Table 3-4, the working degree in the cold-working (finish cold-wire-drawing) performed finally was presented in the column of "Working degree in final working."

The production conditions for the copper alloy wires of Examples according to the present invention and the copper alloy wires of Comparative examples, and the characteristics of the copper alloy wires thus obtained, i.e. the average grain size of matrix and the area ratio of grains having <101> orientation, are presented in Tables 1-1 to 1-3, 2-1 to 2-15, 3-1 to 3-5, and 4-1 to 4-3. Together with those, the area ratio of grains having <100> orientation and the area ratio of grains having <111> orientation, are shown.

### [Characteristics/Physical properties]

With respect to the thus-obtained samples of the round wires and the rectangular wires, characteristics were tested and evaluated.

The tensile strength (TS) and the elongation (EI) were measured for the copper alloy wire after the final-annealing, according to JIS Z2201 and Z2241, respectively. In the tables, these were represented as "Tensile strength (TS) after heating" and "Elongation (EI) after heating," respectively. A case where the tensile strength was 260 MPa or more was judged as passing. A case where the elongation was 30% or more was judged as passing.

The electrical conductivity (EC) was measured, according to JIS H0505. The electrical conductivity of 70%IACS or more was rated as passing, the electrical conductivity of 80%IACS or more was rated as good, the electrical conductivity of 90%IACS or more was rated as excellent, and the electrical conductivity of less than 70%IACS was rated as failed.

The average grain size (GS) was measured by an intercept method (JIS G0551) based on microstructure observation on the cross-section (the transverse cross-section) perpendicular to the longitudinal direction of each sample. In the tables, this was represented simply as "grain size (GS)".

The crystal orientation of the recrystallized texture was measured and evaluated by an EBSD (electron backscatter diffraction) method, as follows. The cross-section perpendicular to the longitudinal direction of a copper alloy wire sample was scanned at a step of 0.02 µm, and the orientation of each grain was observed and analyzed. In analyzing, use was made of an analysis software OIM software (trade name) produced by TSL solutions Co., Ltd. Based on such an analytic results, a plane in which a deviation angle with <101> orientation was within ±10 degrees, was defined as a <101> plane; and a grain which had a plane in which a deviation angle with <101> orientation was within ±10 degrees when a cross-section perpendicular to the longitudinal direction of the copper alloy wire sample was observed by EBSD in a direction normal to the cross-section, was defined as a grain having <101> orientation. Then, the area ratio (%) of grains having <101> orientation was determined, from the ratio, with respect to the entire measurement area, of the area of grains having <101> orientation observed and measured in this way. In each Table, this area ratio is represented as a <101> area ratio. Similarly, it was determined the area ratio (%) of grains having <100> orientation or grains having <111> orientation.

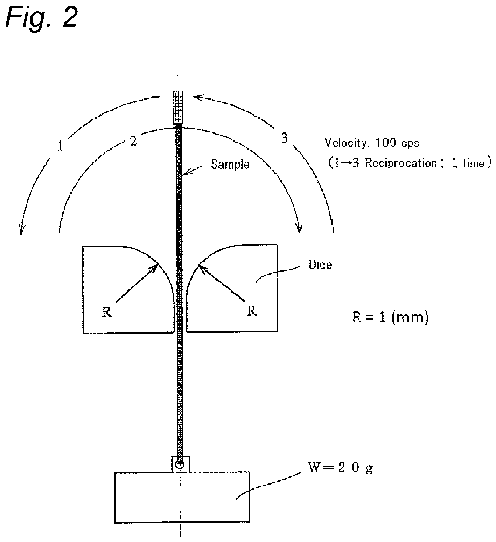

Regarding the service life of the coil, the number of repeating times at breakage in bending fatigue until the test material of the copper alloy wire was broken was measured by performing a bending fatigue test using a device illustrated in Fig. 2, and the service life of the coil was evaluated based on the number of repeating times at breakage in bending fatigue. As illustrated in Fig. 2, a test specimen of a copper alloy wire, as a sample, with a wire diameter φ or wire thickness t was sandwiched between dies, and a load was applied thereon by hanging a weight (W) of 20 g at the lower end of the specimen in order to suppress deflection of the wire. In the case of the rectangular wire, the sample was mounted to be sandwiched between the two dies in the wire thickness direction (ND). The upper end of the specimen was fixed with a connecting jig. While having the specimen maintained in this state, the specimen was bended 90° on the left side and the right side, respectively, bending was repeatedly carried out at a speed of 100 times per minute, and the number of repeating times at breakage in bending was measured for each specimen, i.e. the respective sample. Regarding the number of repeating times in bending, one reciprocation of 1 → 2 → 3 in Fig. 2 was counted as one time, and the distance between the two dies was set to 1 mm so that the specimen of the copper alloy wire would not be compressed in the test. Determination of breakage was made such that the specimen was judged to be broken when the weight hung at the lower end of the specimen dropped. Further, the radius of bending (R) was set to 1 mm, depending on the curvature of the dies. A case where the number of repeating times at breakage in bending until the wire was broken (the number of repeating times at breakage in bending fatigue) was 2,001 times or more was rated as "AA (particularly excellent)," a case where the number of repeating times at breakage in bending was 1,001 to 2,000 times was rated as "A (excellent)," a case where the number of repeating times at breakage in bending was 501 to 1,000 times was rated as "B (good)," and a case where the number of repeating times at breakage in bending was 500 times or less was rated as "D (poor)."

Regarding the coil formability, the frequency of occurrence of wire breakage when 100 km of the test material of the copper alloy wire was wound into a coil having a diameter of 3 mm (φ3 mm) was tested, and the evaluation was carried out at wire breakage frequency per 100 km. A case where the frequency of occurrence of wire breakage was 0 times or more but less than 0.3 times was rated as "A (excellent)," a case where the frequency of occurrence of wire breakage was 0.3 times or more but less than 0.6 times was rated as "B (good)," a case where the frequency of occurrence of wire breakage was 0.6 times or more but less than 1.0 times was rated as "C (acceptable)," and a case where the frequency of occurrence of wire breakage was 1.0 times or more was rated as "D (poor)."

The comprehensive evaluation was determined from the tensile strength, the elongation, the electrical conductivity, and the coil characteristics (the service life of the coil, and the coil formability) described above, and a sample excellent as a copper alloy wire for an extra-fine coil at a low cost was rated as "A (excellent)," while other samples were successively rated as "B (good)," "C (acceptable)," and "D (poor)."

Characteristics of round wire samples (Examples 1 to 7) according to the present examples and round wire samples (Comparative examples 1 to 10), in which the Cu-2% Ag alloy wire was worked to have a final wire diameter of 0.1 mm (φ0.1 mm), and subjected to heating, were measured and evaluated, and the results thereof are presented in Tables 1-1 to 1-3.

**Table 1-1**

| | Composition* | Ingot diameter | Cold-working 1 | | Heating 1 | | | Cold-working 2 | | Heating 2 | | |
|---|---|---|---|---|---|---|---|---|---|---|---|---|
| | Ag | | Wire diameter | Working degree | Manner | Heating temp. | Heating time | Wire diameter | Working degree | Manner | Heating temp. | Heating time |
| | mass% | mm | mm | | | °C | | mm | | | °C | |
| Ex 1 | 2.00 | 10 | 2.60 | 2.7 | Running | 650 | 1 sec | 0.50 | 3.3 | Running | 650 | 1 sec |
| Ex 2 | 2.00 | 10 | 2.60 | 2.7 | Running | 650 | 1 sec | 0.50 | 3.3 | Running | 650 | 1 sec |
| Ex 3 | 2.00 | 10 | 2.60 | 2.7 | Running | 650 | 1 sec | 0.50 | 3.3 | Running | 650 | 1 sec |
| Ex 4 | 2.00 | 10 | 2.60 | 2.7 | Running | 650 | 1 sec | 0.50 | 3.3 | Running | 650 | 1 sec |
| Ex 5 | 2.00 | 10 | 2.60 | 2.7 | Running | 650 | 1 sec | 1.00 | 1.9 | Running | 650 | 1 sec |
| Ex 6 | 2.00 | 10 | 2.60 | 2.7 | Running | 650 | 1 sec | 1.00 | 1.9 | Running | 650 | 1 sec |
| Ex 7 | 2.00 | 10 | 2.60 | 2.7 | Running | 650 | 1 sec | 1.00 | 1.9 | Running | 650 | 1 sec |
| C ex 1 | 2.00 | 10 | 2.60 | 2.7 | Running | 650 | 1 sec | 0.80 | 2.4 | Running | 650 | 1 sec |
| C ex 2 | 2.00 | 10 | 1.50 | 3.8 | Running | 650 | 1 sec | 0.10 | 5.4 | Running | 550 | 1 sec |
| C ex 3 | 2.00 | 10 | 3.00 | 2.4 | Running | 650 | 1 sec | 0.10 | 6.8 | Running | 550 | 1 sec |
| C ex 4 | 2.00 | 10 | 8.00 | 0.4 | Running | 650 | 1 sec | 0.10 | 8.8 | Running | 550 | 1 sec |
| C ex 5 | 2.00 | 10 | 0.10 | 9.2 | Running | 550 | 1 sec | - | | | | |
| C ex 6 | 2.00 | 10 | 0.80 | 5.1 | Running | 650 | 1 sec | 0.10 | 4.2 | Running | 550 | 1 sec |
| C ex 7 | 2.00 | 10 | 6.00 | 1.0 | Running | 650 | 1 sec | 0.65 | 4.4 | Running | 650 | 1 sec |
| C ex 8 | 2.00 | 10 | 0.30 | 7.0 | Running | 650 | 1 sec | 0.10 | 2.2 | Running | 550 | 1 sec |
| C ex 9 | 2.00 | 10 | 2.60 | 2.7 | Running | 650 | 1 sec | 0.65 | 2.8 | Running | 650 | 1 sec |
| C ex 10 | 2.00 | 10 | 0.50 | 6.0 | Running | 850 | 1 sec | 0.10 | 3.2 | Running | 550 | 1 sec |

| | | | | | | | | | | | | |
|---|---|---|---|---|---|---|---|---|---|---|---|---|
| Note: * The balance was Cu and unavoidable impurities, and - means not added. "Ex" means Example according to this invention, and "C ex" means Comparative example. The same is applied to hereinafter. | | | | | | | | | | | | |

**Table1-2**

| | Cold-working 3 | | Heating 3 | | | Cold-working 4 | | Heating 4 | | | Working degree in final working |
|---|---|---|---|---|---|---|---|---|---|---|---|
| | Wire diameter | Working degree | Manner | Heating temp. | Heating time | Wire diameter | Working degree | Manner | Heating temp. | Heating time | |
| | mm | | | °C | | mm | | | °C | | |
| Ex 1 | 0.13 | 2.7 | Running | 650 | 1 sec | 0.10 | 0.5 | Running | 650 | 1 sec | 0.5 |
| Ex 2 | 0.17 | 2.2 | Running | 650 | 1 sec | 0.10 | 1.1 | Running | 650 | 1 sec | 1.1 |
| Ex 3 | 0.20 | 1.8 | Running | 650 | 1 sec | 0.10 | 1.4 | Running | 650 | 1 sec | 1.4 |
| Ex 4 | 0.24 | 1.5 | Running | 650 | 1 sec | 0.10 | 1.8 | Running | 650 | 1 sec | 1.8 |
| Ex 5 | 0.30 | 2.4 | Running | 650 | 1 sec | 0.10 | 2.2 | Running | 650 | 1 sec | 2.2 |
| Ex 6 | 0.36 | 2.0 | Running | 650 | 1 sec | 0.10 | 2.6 | Running | 650 | 1 sec | 2.6 |
| Ex 7 | 0.45 | 1.6 | Running | 650 | 1 sec | 0.10 | 3.0 | Running | 650 | 1 sec | 3 |
| C ex 1 | 0.10 | 4.2 | Running | 650 | 1 sec | - | | | | | 4.2 |
| C ex 2 | - | | | | | - | | | | | 5.4 |
| C ex 3 | - | | | | | - | | | | | 6.8 |
| C ex 4 | - | | | | | - | | | | | 8.8 |
| C ex 5 | - | | | | | - | | | | | 9.2 |
| C ex 6 | - | | | | | - | | | | | 4.2 |
| C ex 7 | 0.40 | 1.0 | Running | 650 | 1 sec | 0.10 | 2.8 | Running | 550 | 1 sec | 2.8 |
| C ex 8 | - | | | | | - | | | | | 2.2 |
| C ex 9 | 0.20 | 2.4 | Running | 400 | 1 sec | 0.10 | 1.4 | Running | 650 | 1 sec | 1.4 |
| C ex 10 | - | | | | | - | | | | | 3.2 |

**Table 1-3**

| | Grain size | <101> area ratio | <100> area ratio | <111> area ratio | Characteristics | | | | | |
|---|---|---|---|---|---|---|---|---|---|---|
| | | | | | EI after heating | TS after heating | EC | Coil service life | Coil formability | Comprehensive evaluation |
| | µm | % | % | % | % | MPa | %IACS | | | |
| Ex 1 | 1.50 | 21 | 45 | 34 | 37 | 323 | 92 | A | A | B |
| Ex 2 | 2.20 | 24 | 38 | 38 | 38 | 312 | 91 | A | A | A |
| Ex 3 | 2.10 | 27 | 45 | 28 | 36 | 311 | 92 | A | A | A |
| Ex 4 | 1.80 | 21 | 33 | 46 | 37 | 312 | 92 | A | A | A |
| Ex 5 | 1.10 | 11 | 55 | 34 | 31 | 315 | 91 | A | B | A |
| Ex 6 | 0.80 | 18 | 47 | 35 | 32 | 309 | 92 | A | B | A |
| Ex 7 | 0.50 | 14 | 43 | 43 | 31 | 315 | 92 | A | B | A |
| C ex 1 | 0.10 | 5 | 23 | 72 | 16 | 318 | 91 | B | D | D |
| C ex 2 | 0.10 | 7 | 25 | 68 | 19 | 312 | 90 | B | D | D |
| C ex 3 | 0.20 | 3 | 16 | 81 | 15 | 311 | 91 | B | D | D |
| Cex4 | 0.10 | 5 | 16 | 79 | 18 | 313 | 92 | B | D | D |
| C ex 5 | 0.20 | 2 | 17 | 81 | 19 | 310 | 91 | B | D | D |
| C ex 6 | 0.10 | 5 | 25 | 70 | 17 | 305 | 91 | B | D | D |
| C ex 7 | 1.10 | 5 | 55 | 40 | 16 | 407 | 92 | AA | D | D |
| C ex 8 | 2.20 | 7 | 21 | 72 | 16 | 309 | 91 | B | D | D |
| C ex 9 | 1.50 | 2 | 26 | 72 | 18 | 315 | 90 | B | D | D |
| C ex 10 | 7.50 | 3 | 17 | 80 | 15 | 314 | 91 | B | D | D |

In all of Examples 1 to 7, since the working and heating conditions were properly adjusted such that the area ratio of the texture of <101> orientation became 10% or more, both the elongation and the tensile strength were high, that is, 25% or more and 300 MPa or more, respectively, and good characteristics of the electrical conductivity, the service life of the coil, and coil formability, were also exhibited. In particular, in Examples 1 to 4 in which the final working degree (η) in the final cold-working before the final-annealing was 0.5 or more but 2 or less, the area ratio of the <101> texture was 20% or more, the elongation was high, that is, 35% or more, and better characteristics of the coil formability, were exhibited.

Contrary to the above, in Comparative examples 1 to 6, since the final cold-working degree was too large, the area ratio of <101> texture was small, and the elongation and the coil formability were poor. In Comparative example 7, since the temperature in the final heating was too low of the semi-softening temperature, the area ratio of <101> texture was small, and, although the tensile strength was high and the service life of coil was good, the elongation and the coil formability were poor. In Comparative example 8, since the working degree (η) before the intermediate annealing was more than 4, that is, too large, the texture of <111> orientation largely remained, the area ratio of the texture of <101> orientation was small, and the elongation and the coil formability were poor. In Comparative example 9, since the intermediate annealing was not sufficient, and thus working strain could not be sufficiently removed so that the working strain was held until the next step, the area ratio of the <101> texture was small, and the elongation and the coil formability were poor. In Comparative example 10, since the working degree before heating was too high and the temperature of the intermediate annealing was also too high, grains were coarsened, and the elongation and the coil formability were poor. In all of these Comparative examples 1 to 10, the coil formability was poor as well as the elongation.

In this way, according to the present invention, by properly adjusting the heating temperature and working degree, it is possible to control the <101> texture, and to obtain a copper alloy wire that has the physical strength and the elongation at a higher level and is also excellent in coil characteristics.

Examples and Comparative examples of copper alloy round wires having various alloy compositions other than a Cu-2% Ag alloy are presented in Tables 2-1 to 2-15.

In Tables, in the column of "Working degree in final working," the working degrees in the final finish-cold-working (x-th, x = final) performed immediately before heating x (x-th, x = final) finally performed among "Heatings 1 to 5" were presented.

**Table 2-1**

| | Composition* | | | | | | | | | Ingot diameter |
|---|---|---|---|---|---|---|---|---|---|---|
| | Ag | Mg | Sn | In | Zn | Ni | Cr | Zr | Co | |
| | mass% | mass% | mass% | mass% | mass% | mass% | mass% | mass% | mass% | mm |
| Ex 12 | 0.10 | - | - | - | - | - | - | - | - | 22 |
| Ex 13 | 0.10 | - | - | - | - | - | - | - | - | 10 |
| Ex 14 | 0.50 | - | - | - | - | - | - | - | - | 10 |
| Ex 17 | 1.00 | - | - | - | - | - | - | - | - | 10 |
| Ex 19 | 1.00 | - | - | - | - | - | - | - | - | 16 |
| Ex 21 | 3.00 | - | - | - | - | - | - | - | - | 10 |
| Ex 24 | 4.00 | 4.00 | - | - | - | - | - | - | - | 10 |
| Ex 25 | 4.00 | - | - | - | - | - | - | - | - | 20 |
| Ex 26 | - | 0.10 | - | - | - | - | - | - | - | 10 |
| Ex 28 | - | 0.30 | - | - | - | - | - | - | - | 10 |
| Ex 30 | - | - | 0.10 | - | - | - | - | - | - | 20 |
| Ex 31 | - | - | 0.30 | - | - | - | - | - | - | 12 |
| Ex 33 | - | - | - | 0.30 | - | - | - | - | - | 16 |
| Ex 37 | - | - | - | - | - | 0.30 | - | - | - | 20 |
| Ex 41 | - | - | - | - | - | - | - | 0.30 | - | 22 |
| Ex 42 | - | - | - | - | - | - | - | - | 0.10 | 10 |

| | | | | | | | | | | |
|---|---|---|---|---|---|---|---|---|---|---|
| Note: * The balance was Cu and unavoidable impurities, and "-" means not added. | | | | | | | | | | |

**Table 2-2**

| | Cold-working 1 | | Heating 1 | | | Cold-working 2 | | Heating 2 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| Ex 12 | 10.00 | 1.6 | Running | 550 | 1 sec | 4.00 | 1.8 | Running | 500 | 1 sec |
| Ex 13 | 2.00 | 3.2 | Batch | 450 | 1 hr | 0.30 | 3.8 | Running | 500 | 1 sec |
| Ex 14 | 2.60 | 2.7 | Batch | 420 | 1 hr | 0.50 | 3.3 | Batch | 420 | 1 hr |
| Ex 17 | 2.60 | 2.7 | Batch | 450 | 1 hr | 0.50 | 3.3 | Running | 550 | 1 sec |
| Ex 19 | 2.60 | 3.6 | Batch | 430 | 1 hr | 0.40 | 3.7 | Batch | 440 | 1 hr |
| Ex 21 | 2.60 | 2.7 | Batch | 550 | 2 hr | 0.50 | 3.3 | Batch | 550 | 2 hr |
| Ex 24 | 2.60 | 2.7 | Running | 700 | 0.5 sec | 0.90 | 2.1 | Running | 700 | 0.5 sec |
| Ex 25 | 3.20 | 3.7 | Batch | 550 | 1 hr | 0.50 | 3.7 | Batch | 550 | 1 hr |
| Ex 26 | 2.60 | 2.7 | Batch | 420 | 1 hr | 0.50 | 3.3 | Running | 500 | 1 sec |
| Ex 28 | 2.00 | 3.2 | Batch | 380 | 2 hr | 0.50 | 2.8 | Batch | 380 | 2 hr |
| Ex 30 | 5.00 | 2.8 | Batch | 300 | 1 hr | 2.60 | 1.3 | Electric | 500 | 3 sec |
| Ex 31 | 2.60 | 3.1 | Running | 420 | 1 sec | 0.60 | 2.9 | Running | 420 | 1 sec |
| Ex 33 | 2.60 | 3.6 | Batch | 400 | 1 hr | 0.50 | 3.3 | Electric | 450 | 0.3 sec |
| Ex 37 | 5.00 | 2.8 | Batch | 430 | hr | 1.00 | 3.2 | Batch | 400 | 1 hr |
| Ex 41 | 8.00 | 2.0 | Batch | 400 | 1 hr | 2.60 | 2.2 | 530 | 530 | 4 sec |
| Ex 42 | 2.60 | 2.7 | Electric | 520 | 0.5 sec | 0.50 | 3.3 | Running | 530 | 0.5 sec |

**Table 2-3**

| | Cold-working 3 | Heating 3 | | | Cold-working 4 | | Heating 4 | | | |
|---|---|---|---|---|---|---|---|---|---|---|
| | Wire Working diameter degree | Manner | Heating temp. | Heating time | Wire diameter | Working degree | Manner | Heating temp. | Heating time | |
| | mm | | °C | | mm | | | °C | | |
| Ex 12 | 0.80 | 3.2 | Batch | 430 | 30 min | 0.12 | 3.8 | Electric | 500 | 1 sec |
| Ex 13 | 0.08 | 2.6 | Batch | 450 | 30 min | - | | | | |
| Ex 14 | 0.10 | 3.2 | Batch | 430 | 1 hr | 0.05 | 1.4 | Batch | 450 | 1 hr |
| Ex 17 | 0.10 | 3.2 | Batch | 450 | 1 hr | 0.03 | 2.4 | Batch | 450 | 30 min |
| Ex 19 | 0.06 | 3.8 | Batch | 440 | 1 hr | 0.04 | 0.8 | Batch | 450 | 1 hr |
| Ex 21 | 0.10 | 3.2 | Batch | 500 | 2 hr | 0.03 | 2.4 | Batch | 550 | 2 hr |
| Ex 24 | 0.20 | 3.0 | Batch | 550 | hr | 0.08 | 1.8 | Running | 800 | 0.5 sec |
| Ex 25 | 0.10 | 3.2 | Batch | 800 | 1 hr | 0.04 | 1.8 | Batch | 650 | 1 hr |
| Ex 26 | 0.10 | 3.2 | Batch | 400 | 1 hr | 0.03 | 2.4 | Batch | 400 | 30 min |
| Ex 28 | 0.10 | 3.2 | Batch | 400 | 2 hr | 0.04 | 1.8 | Batch | 400 | 2 hr |
| Ex 30 | 0.50 | 373 | Electric | 500 | 3 sec | 0.10 | 3.2 | Electric | 500 | 3 sec |
| Ex 31 | 0.10 | 3.6 | Running | 420 | 1 sec | 0.04 | 1.8 | Running | 480 | 1 sec |
| Ex 33 | 0.10 | 3.2 | Batch | 300 | 1 hr | 0.03 | 2.4 | Batch | 400 | 1 hr |
| Ex 37 | 0.20 | 3.2 | Batch | 400 | 1 hr | 0.08 | 1.8 | Batch | 450 | 1 hr |
| Ex 41 | 1.00 | 1.9 | Batch | 420 | 1 hr | 0.15 | 3.8 | Running | 520 | 4 sec |
| Ex 42 | 0.10 | 3.2 | Electric | 540 | 0.5 sec | 0.03 | 2.4 | Electric | 500 | 0.5 sec |

**Table 2-4**

| | Cold-working 5 | | Heating 5 | | | Working degree in final working |
|---|---|---|---|---|---|---|
| | Wire diameter | Working degree | Manner | Heating temp. | Heating time | |
| | mm | | | °C | | |
| Ex 12 | 0.08 | 0.8 | Batch | 450 | 1 hr | 0.8 |
| Ex 13 | | | - | | | 2.6 |
| Ex 14 | | | - | | | 1.4 |
| Ex 17 | - | | | | | 2.4 |
| Ex 19 | - | | | | | 0.8 |
| Ex 21 | - | | | | | 2.4 |
| Ex 24 | - | | | | | 1.8 |
| Ex 25 | - | | | | | 1.8 |
| Ex 26 | - | | | | | 2.4 |
| Ex 28 | - | | | | | 1.8 |
| Ex 30 | 0.07 | 0.7 | Electric | 550 | 3 sec | 0.7 |
| Ex 31 | - | | | | | 1.8 |
| Ex 33 | - | | | | | 2.4 |
| Ex 37 | - | | | | | 1.8 |
| Ex 41 | 0.05 | 2.2 | Running | 550 | 4 sec | 2.2 |
| Ex 42 | - | | | | | 2.4 |

**Table 2-5**

| | Grain size | <101> area ratio | <100> area ratio | <111> area ratio | Characteristics | | | | | |
|---|---|---|---|---|---|---|---|---|---|---|
| | | | | | EI after heating | TS after heating | EC | Coil service life | Coil formability | Comprehensive evaluation |
| | µm | % | % | % | % | MPa | %IACS | | | |
| Ex 12 | 1.00 | 21 | 75 | 16 | 36 | 303 | 100 | A | A | A |
| Ex 13 | 0.20 | 15 | 55 | 30 | 32 | 304 | 100 | A | B | A |
| Ex 14 | 3.00 | 23 | 65 | 16 | 35 | 305 | 99 | A | B | A |
| Ex 17 | 1.50 | 16 | 57 | 11 | 32 | 309 | 94 | A | B | A |
| Ex 19 | 1.00 | 22 | 77 | 11 | 36 | 307 | 95 | A | A | A |
| Ex 21 | 2.00 | 13 | 55 | 16 | 31 | 316 | 90 | A | B | A |
| Ex 24 | 0.30 | 26 | 65 | 9 | 35 | 322 | 88 | A | B | A |
| Ex 25 | 7.00 | 28 | 67 | 7 | 37 | 323 | 88 | A | A | A |
| Ex 26 | 0.30 | 17 | 56 | 11 | 31 | 281 | 90 | B | B | B |
| Ex 28 | 0.40 | 26 | 62 | 6 | 36 | 278 | 75 | B | A I | A |
| Ex 30 | 0.60 | 25 | 76 | 12 | 36 | 284 | 9 | B | A | A |
| Ex 31 | 0.50 | 26 | 62 | 15 | 35 | 295 | 77 | B | B | B |
| Ex 33 | 0.30 | 14 | 55 | 13 | 32 | 286 | 80 | B | B | B |
| Ex 37 | 0.50 | 23 | 70 | 17 | 37 | 279 | 83 | B | A | A |
| Ex 41 | 1.00 | 18 | 55 | 13 | 32 | 281 | 90 | B | B | B |
| Ex 42 | 0.80 | 17 | 53 | 15 | 31 | 279 | 89 | B | B | B |

**Table 2-6**

| | Composition* | | | | | | | | | Ingot diameter |
|---|---|---|---|---|---|---|---|---|---|---|
| | Ag | Mg | Sn | In | Zn | Ni | Cr | Lr | Co | |
| | mass% | mass | mass% | mass% | mass% | mass% | mass% | mass% | mass% | mm |
| Ex 69 | 0.05 | - | - | - | - | - | 0.10 | 0.05 | - | 10 |
| Ex 70 | - | - | - | - | - | - | 0.10 | 0.10 | - | 8 |
| Ex 71 | - | 0.15 | - | - | 0.20 | - | - | - | - | 15 |

| | | | | | | | | | | |
|---|---|---|---|---|---|---|---|---|---|---|
| Note: * The balance was Cu and unavoidable impurities, and "-" means not added. | | | | | | | | | | |

**Table 2-7**

| | Cold-working 1 | | Heating 1 | | | Cold-working 2 | | Heating 2 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| Ex 69 | 2.60 | 2.7 | Batch | 480 | 1 hr | 1.50 | 1.1 | Running | 570 | 2 sec |
| Ex 70 | 2.00 | 2.8 | Batch | 400 | 1 hr | 0.30 | 3.8 | Running | 670 | 2 sec |
| Ex 71 | 5.00 | 2.2 | Electric | 520 | 0.5 sec | 2.00 | 1.8 | Batch | 420 | 30 min |

**Table 2-8**

| | Cold-working 3 | | Heating 3 | | | Cold-working 4 | | Heating 4 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| Ex 69 | 0.65 | 1.7 | Batch | 480 | 1 hr | 0.10 | 3.7 | Running | 570 | 2 sec |
| Ex 70 | 0.08 | 2.6 | Running | 600 | 2 sec | - | | | | |
| Ex 71 | 0.30 | 3.8 | Electric | 520 | 0.5 sec | 008 | 2.6 | Batch | 420 | 30 min |

**Table 2-9**

| | Cold-working 5 | | Heating 5 | | | Working degree in final working |
|---|---|---|---|---|---|---|
| | Wire diameter | Working degree | Manner | Heating temp. | Heating time | |
| | mm | | | °C | | |
| Ex 69 | 0.04 | 1.8 | Batch | 480 | 2 hr | 1.8 |
| Ex 70 | - | | | | | 2.6 |
| Ex 71 | 0.05 | 0.9 | Running | 500 | 1 sec | 0.9 |

**Table 2-10**

| | Grain size | <101> area ratio | <100> area ratio | <111> area ratio | Characteristics | | | | | |
|---|---|---|---|---|---|---|---|---|---|---|
| | | | | | EI after heating | TS after heating | EC | Coil service life | Coil formability | Comprehensive evaluation |
| | µm | % | % | % | % | MPa | %IACS | | | |
| Ex 69 | 2.00 | 26 | 67 | 28 | 36 | 305 | 90 | A | A | A |
| Ex 70 | 3.00 | 15 | 55 | 30 | 31 | 275 | 85 | B | B | B |
| Ex 71 | 3.00 | 28 | 77 | 18 | 37 | 276 | 80 | B | A | A |

**Table 2-11**

| | Composition* | | | | | | | | | Ingot diameter |
|---|---|---|---|---|---|---|---|---|---|---|
| | Ag | Mg | Sn | In | Zn | Ni | Cr | Zr | Co | |
| | mass% | mass% | mass% | mass% | mass% | mass% | mass% | mass% | mass% | mm |
| C ex 11 | 0.50 | - | - | - | - | - | - | - | - | 10 |
| C ex 12 | 1.00 | - | - | - | - | - | - | - | - | 10 |
| C ex 13 | 1.00 | - | - | - | - | - | - | - | - | 16 |
| C ex 14 | 1.00 | - | - | - | - | - | - | - | - | 10 |
| C ex 15 | 3.00 | - | - | - | - | - | - | - | - | 20 |
| C ex 16 | 3.00 | - | - | - | - | - | - | - | - | 10 |
| C ex 17 | 3.00 | - | - | - | - | - | - | - | - | 20 |
| C ex 18 | - | 0.10 | - | - | - | - | - | - | - | 10 |
| C ex 19 | - | - | 0.20 | - | - | - | - | - | - | 20 |
| C ex 20 | - | - | - | 0.10 | - | - | - | - | - | 10 |
| C ex 21 | - | - | - | - | 0.10 | | - | - | - | 8 |
| C ex 22 | - | - | - | - | - | 0.10 | - | - | - | 10 |
| C ex 23 | - | - | - | - | - | - | 0.10 | - | - | 8 |
| C ex 24 | - | - | - | - | - | - | - | 0.10 | - | 10 |
| C ex 25 | - | - | - | - | - | - | - | - | 0.10 | 8 |
| C ex 26 | 0.05 | - | - | - | - | - | - | - | - | 10 |
| C ex 27 | - | 0.03 | - | - | - | - | - | - | - | 20 |
| C ex 28 | - | 0.40 | - | - | - | - | - | - | - | 10 |
| C ex 29 | - | - | 0.02 | - | - | - | - | - | - | 20 |
| C ex 30 | - | - | 0.50 | - | - | - | - | - | - | 8 |
| C ex 31 | - | - | - | 0.03 | - | - | - | - | - | 20 |
| C ex 32 | - | - | - | - | 0.03 | - | - | - | - | 8 |
| C ex 33 | - | - | - | - | - | 0.60 | - | - | - | 10 |
| C ex 34 | - | - | - | - | - | - | 0.03 | - | - | 20 |
| C ex 35 | - | - | - | - | - | - | - | 0.02 | - | 20 |
| C ex 36 | - | - | - | - | - | - | - | - | 0.80 | 10 |
| C ex 37 | - | - | 0.50 | - | 0.30 | - | - | - | - | 10 |
| C ex 38 | 0.05 | - | 0.03 | - | - | 0.05 | - | - | - | 15 |
| C ex 39 | 3.00 | 0.10 | 0.50 | - | - | - | - | - | - | 15 |
| C ex 40 | 5.00 | - | 0.30 | - | - | 0.40 | - | - | - | 10 |

| | | | | | | | | | | |
|---|---|---|---|---|---|---|---|---|---|---|
| Note: * The balance was Cu and unavoidable impurities, and "- means not added. | | | | | | | | | | |

**Table 2-12**

| | Cold-workinq 1 | | Heating 1 | | | Cold-working 2 | | Heating 2 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| C ex 11 | 0.05 | 10.6 | Running | 620 | 0.5 sec | - | | | | |
| C ex 12 | 0.90 | 4.8 | Running | 550 | 1 sec | 0.10 | 4.4 | Running | 550 | 1 sec |
| C ex 13 | 2.60 | 3.6 | Batch | 500 | 1 hr | 0.50 | 3.3 | Batch | 800 | 1 hr |
| C ex 14 | 2.60 | 2.7 | Running | 550 | 1 sec | 0.50 | 3.3 | Running | 350 | 1 sec |
| C ex 15 | 0.04 | 12.4 | Running | 650 | 1 sec | - | | | | |
| C ex 16 | 2.60 | 2.7 | Electric | 650 | 2 sec | 0.40 | 3.7 | Electric | 400 | 2 sec |
| C ex 17 | 2.60 | 4.1 | Batch | 550 | 1 hr | 1.00 | 1.9 | Running | 680 | 1 sec |
| C ex 18 | 2.00 | 3.2 | Running | 550 | 1 sec | 0.30 | 3.8 | Running | 520 | 1 sec |
| C ex 19 | 0.05 | 12.0 | Batch | 400 | 2 hr | - | | | | |
| C ex 20 | 2.60 | 2.7 | Running | 520 | 1 sec | 0.50 | 3.3 | Running | 250 | 1 sec |
| C ex 21 | 1.50 | 3.3 | Batch | 400 | 2 hr | 1.00 | 0.8 | Batch | 420 | 2 hr |
| C ex 22 | 5.00 | 1.4 | Batch | 430 | 30 min | 0.04 | 9.7 | Batch | 420 | 30 min |
| C ex 23 | 1.50 | 3.3 | Electric | 600 | 2 sec | 0.25 | 3.6 | Batch | 400 | 30 min |
| C ex 24 | 0.08 | 9.7 | Batch | 450 | 1 hr | - | | | | |
| C ex 25 | 1.50 | 3.3 | Running | 250 | 1 sec | 0.30 | 3.2 | Batch | 400 | 1 hr |
| C ex 26 | 2.00 | 3.2 | Batch | 480 | 1 hr | 0.50 | 2.8 | Running | 570 | 2 sec |
| C ex 27 | 10.00 | 1.4 | Batch | 430 | 30 min | 2.60 | 2.7 | Running | 480 | 1 sec |
| C ex 28 | 2.60 | 2.7 | Running | 480 | 1 sec | 0.50 | 3.3 | Batch | 400 | 1 hr |
| C ex 29 | 8.00 | 1.8 | Batch | 420 | 1 hr | 2.60 | 2.2 | Batch | 430 | 30 min |
| C ex 30 | 2.00 | 2.8 | Batch | 430 | 30 min | 0.50 | 2.8 | Running | 480 | 1 sec |
| C ex 31 | 1.00 | 6.0 | Running | 480 | 1 sec | 0.50 | 1.4 | Electric | 500 | 0.3 sec |
| C ex 32 | 2.60 | 2.2 | Electric | 510 | 0.5 sec | 1.50 | 1.1 | Running | 480 | 1 sec |
| C ex 33 | 5.00 | 1.4 | Batch | 430 | 30 min | 1.00 | 3.2 | Running | 500 | 0.5 sec |
| C ex 34 | 8.00 | 1.8 | Running | 480 | 1 sec | 2.00 | 2.8 | Electric | 480 | 1 sec |
| C ex 35 | 10.00 | 1.4 | Batch | 480 | 1 hr | 1.50 | 3.8 | Running | 570 | 2 sec |
| C ex 36 | 1.50 | 3.8 | Running | 480 | 1 sec | 0.25 | 3.6 | Batch | 430 | 30 min |
| C ex 37 | 1.00 | 4.6 | Batch | 420 | 1 hr | 0.50 | 1.4 | Batch | 430 | 30 min |
| C ex 38 | 2.60 | 3.5 | Batch | 480 | 1 hr | 0.40 | 3.7 | Batch | 500 | 2 hr |
| C ex 39 | 2.20 | 3.8 | Running | 700 | 1 sec | 0.35 | 3.7 | Batch | 530 | 1 hr |
| C ex 40 | 2.00 | 3.2 | Running | 730 | 0.5 sec | 0.45 | 3.0 | Electric | 730 | 0.5 sec |

**Table 2-13**

| | Cold-working 3 | | Heating 3 | | | Cold-working 4 | | Heating 4 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| C ex 11 | - | | | | | - | | | | |
| C ex 12 | 0.03 | 2.4 | Running | 600 | 1 sec | - | | | | |
| C ex 13 | 0.05 | 4.6 | Running | 550 | 1 sec | - | | | | |
| C ex 14 | 0.10 | 3.2 | Running | 550 | 1 sec | 0.08 | 0.4 | Running | 510 | 1 sec |
| C ex 15 | - | | | | | - | | | | |
| C ex 16 | 0.06 | 3.8 | Electric | 650 | 2 sec | - | | | | |
| C ex 17 | 0.30 | 2.4 | Running | 680 | 1 sec | 0.06 | 3.2 | Batch | 550 | 1 hr |
| C ex 18 | 0.03 | 4.6 | Electric | 600 | 2 sec | - | | | | |
| C ex 19 | - | | | | | - | | | | |
| C ex 20 | 0.07 | 3.9 | Electric | 500 | 1 sec | - | | | | |
| C ex 21 | 0.25 | 2.8 | Electric | 530 | 0.6 sec | 0.03 | 4.2 | Batch | 420 | 30 min |
| C ex 22 | - | | | | | - | | | | |
| C ex 23 | 0.03 | 4.2 | Electric | 500 | 0.2 sec | - | | | | |
| C ex 24 | - | | | | | - | | | | |
| C ex 25 | 0.06 | 3.2 | Running | 500 | 1 sec | - | | | | |
| C ex 26 | 0.20 | 1.8 | Batch | 480 | 1 hr | 0.10 | 1.4 | Electric | 570 | 1 sec |
| C ex 27 | 0.60 | 2.9 | Batch | 430 | 30 min | 0.10 | 3.6 | Batch | 420 | 1 hr |
| C ex 28 | 0.08 | 3.7 | Running | 550 | 1 sec | - | | | | |
| C ex 29 | 1.50 | 1.1 | Batch | 400 | 1 hr | 0.80 | 1.3 | Batch | 400 | 1 hr |
| C ex 30 | 0.08 | 3.7 | Running | 500 | 1 sec | - | | | | |
| C ex 31 | 0.10 | 3.2 | Batch | 430 | 30 min | 0.05 | 1.4 | Running | 500 | 0.5 sec |
| C ex 32 | 0.50 | 2.2 | Batch | 400 | 2 hr | 0.10 | 3.2 | Electric | 500 | 0.3 sec |
| C ex 33 | 0.10 | 4.6 | Running | 550 | 1 sec | - | | | | |
| C ex 34 | 0.30 | 3.8 | Batch | 430 | 1 hr | 0.08 | 2.6 | Batch | 420 | 1 hr |
| C ex 35 | 0.30 | 3.2 | Batch | 480 | 1 hr | 0.10 | 2.2 | Batch | 460 | 1 hr |
| C ex 36 | 0.05 | 3.2 | Batch | 450 | 2 hr | - | | | | |
| C ex 37 | 0.20 | 1.8 | Electric | 500 | 0.3 sec | 0.10 | 1.4 | Batch | 480 | 1 hr |
| C ex 38 | 0.07 | 3.5 | Batch | 450 | 30 min | - | | | | |
| C ex 39 | 0.10 | 2.5 | Running | 700 | 1 sec | 0.03 | 2.4 | Batch | 600 | 2 hr |
| C ex 40 | 0.10 | 3.0 | Batch | 530 | 1 hr | 0.02 | 3.2 | Running | 750 | 0.5 sec |

**Table 2-14**

| | Cold-working 5 | | Heating 5 | | | Working degree in final working |
|---|---|---|---|---|---|---|
| | Wire diameter | Working degree | Manner | Heating temp. | Heating time | |
| | mm | | | °C | | |
| C ex 11 | - | | | | | 10.6 |
| C ex 12 | - | | | | | 2.4 |
| C ex 13 | - | | | | | 4.6 |
| C ex 14 | - | | | | | 0.4 |
| C ex 15 | - | | | | | 12.4 |
| C ex 16 | - | | | | | 3.8 |
| C ex 17 | - | | | | | 3.2 |
| C ex 18 | - | | | | | 4.6 |
| C ex 19 | - | | | | | 12.0 |
| C ex 20 | - | | | | | 3.9 |
| C ex 21 | - | | | | | 4.2 |
| C ex 22 | - | | | | | 9.7 |
| C ex 23 | - | | | | | 4.2 |
| C ex 24 | - | | | | | 9.7 |
| C ex 25 | - | | | | | 3.2 |
| C ex 26 | 0.04 | 1.8 | Batch | 450 | 30 min | 1.8 |
| C ex 27 | - | | | | | 3.6 |
| C ex 28 | - | | | | | 3.7 |
| C ex 29 | 0.10 | 4.2 | Running | 500 | 0.5 sec | 4.2 |
| C ex 30 | - | | | | | 3.7 |
| C ex 31 | - | | | | | 1.4 |
| C ex 32 | 0.06 | 1.0 | Electric | 500 | 0.5 sec | 1.0 |
| C ex 33 | - | | | | | 4.6 |
| C ex 34 | - | | | | | 2.6 |
| C ex 35 | - | | | | | 2.2 |
| C ex 36 | - | | | | | 3.2 |
| C ex 37 | 0.03 | 2.4 | Batch | 400 | 1 hr | 2.4 |
| C ex 38 | - | | | | | 3.5 |
| C ex 39 | - | | | | | 2.4 |
| C ex 40 | - | | | | | 3.2 |

**Table 2-15**

| | Grain size | <101> area ratio | <100> area ratio | <111> area ratio | Characteristics | | | | | |
|---|---|---|---|---|---|---|---|---|---|---|
| | | | | | EI after heating | TS after heating | EC | Coil service life | Coil formability | Comprehensive evaluation |
| | µm | % | % | % | % | MPa | %IACS | | | |
| C ex 11 | 0.10 | 2 | 21 | 71 | 17 | 304 | 99 | A | D | D |
| C ex 12 | 0.30 | 8 | 23 | 65 | 16 | 306 | 96 | A | D | D |
| C ex 13 | 7.00 | 2 | 21 | 57 | 15 | 308 | 95 | A | D | D |
| C ex 14 | 1.20 | 3 | 17 | 63 | 18 | 304 | 96 | A | D | D |
| C ex 15 | 0.10 | 1 | 19 | 71 | 16 | 315 | 91 | A | D | D |
| C ex 16 | 2.00 | 3 | 22 | 66 | 15 | 316 | 90 | A | D | D |
| C ex 17 | 1.00 | 2 | 19 | 69 | 14 | 317 | 91 | A | D | D |
| C ex 18 | 10.00 | 3 | 21 | 69 | 16 | 289 | 90 | B | D | D |
| C ex 19 | 0.20 | 1 | 22 | 66 | 13 | 279 | 84 | B | D | D |
| C ex 20 | 0.70 | 3 | 22 | 66 | 18 | 283 | 90 | B | D | D |
| C ex 21 | 0.40 | 4 | 28 | 61 | 16 | 267 | 98 | B | D | D |
| C ex 22 | 1.00 | 1 | 26 | 62 | 15 | 264 | 93 | B | D | D |
| C ex 23 | 10.00 | 3 | 26 | 62 | 16 | 267 | 95 | B | D | D |
| C ex 24 | 0.10 | 1 | 12 | 76 | 17 | 278 | 98 | B | D | D |
| C ex 25 | 2.00 | 3 | 25 | 68 | 13 | 281 | 89 | B | D | D |
| C ex 26 | 1.20 | 1b | 65 | 25 | 36 | 254 | 100 | D | A | D |
| C ex 27 | 0.10 | 12 | 41 | 50 | 25 | 249 | 96 | D | C | D |
| C ex 28 | 0.10 | 12 | 35 | 49 | 26 | 297 | 67 | B | C | D |
| C ex 29 | 0.10 | 3 | 25 | 68 | 17 | 246 | 95 | D | D | D |
| C ex 30 | 0.20 | 11 | 41 | 43 | 25 | 281 | 67 | B | C | D |
| C ex 31 | 0.50 | 5 | 28 | 61 | 16 | 250 | 96 | D | D | D |
| C ex 32 | 2.00 | 23 | 74 | 20 | 36 | 245 | 98 | D | A | D |
| C ex 33 | 0.10 | 3 | 22 | 70 | 18 | 276 | 68 | B | D | D |
| C ex 34 | 2.20 | 14 | 57 | 31 | 32 | 248 | 99 | D | B | D |
| C ex 35 | 3.20 | 11 | 58 | 29 | 31 | 239 | 99 | D | B | D |
| C ex 36 | 0.10 | 13 | 42 | 49 | 28 | 287 | 67 | B | C | D |
| C ex 37 | 0.10 | 4 | 28 | 62 | 16 | 287 | 66 | B | D | D |
| C ex 38 | 0.10 | 15 | 42 | 45 | 26 | 253 | 98 | D | C | D |
| C ex 39 | 1.80 | 14 | 55 | 39 | 31 | 312 | 60 | A | B | D |
| C ex 40 | 0.10 | 13 | 41 | 51 | 28 | 313 | 60 | A | C | D |

Also in the case of a copper alloy round wire in which (1) Ag and/or (2) at least one element selected from the group consisting of Sn, Mg, Zn, In, Ni, Co, Zr, and Cr are/is added to Cu, similarly to the case of the Cu-Ag alloy, when the <101> texture amount was controlled to be the predetermined area ratio of grains having <101> orientation, characteristics were exhibited, in which the elongation, the physical strength, and the electrical conductivity were high and in which coil characteristics (the service life of the coil, and coil formability) were also excellent. Among them, a round wire of a Cu-Ag-based alloy is higher in physical strength as compared with other copper alloy round wires.

Examples and Comparative examples of rectangular wires are presented in Tables 3-1 to 3-5.

In Tables 3-2 to 3-4, the size after the rectangular wire-working was represented as the thickness t (mm) × the width w (mm). Of "Heating 2, Heating 3, or Heating 4," the rectangular wire-working was performed at a working degree presented in the columns of "Heating 3, Heating 4, or Heating 5" on the round wire having a wire diameter φ (mm) after the finally-performed intermediate heating x (x-th, x = final). The heating presented in the columns of "Heating 3, Heating 4, or Heating 5" which was finally performed is the final heating (final-annealing).

**Table 3-1**

| | Composition* | | | | | | | | | Ingot diameter |
|---|---|---|---|---|---|---|---|---|---|---|
| | Ag | Mg | Sn | In | Zn | Ni | Cr | Zr | Co | |
| | mass% | mass% | mass% | mass% | mass% | mass% | mass% | mass% | mass% | mm |
| Ex 75 | 0.10 | - | - | - | - | - | - | - | - | 10 |
| Ex 76 | 0.50 | - | - | - | - | - | - | - | - | 22 |
| Ex 77 | 1.00 | - | - | - | - | - | - | - | - | 16 |
| Ex 78 | 2.00 | - | - | - | - | - | - | - | - | 10 |
| Ex 79 | 4.00 | - | - | - | - | - | - | - | - | 10 |
| Ex 80 | - | 0.30 | - | - | - | - | - | - | - | 10 |
| Ex 81 | - | - | 0.30 | - | - | - | - | - | - | 12 |
| Ex 82 | - | - | - | - | - | 0.10 | - | - | - | 10 |
| Ex 83 | - | - | - | - | - | - | 0.10 | - | - | 10 |
| Ex 84 | - | - | - | - | - | - | - | 0.30 | - | 22 |
| Ex 85 | - | - | - | - | - | - | - | - | 0.10 | 10 |
| C ex 41 | 1.00 | - | - | - | - | - | - | - | - | 10 |
| C ex 42 | 3.00 | - | - | - | - | - | - | - | - | 20 |
| C ex 43 | - | 0.10 | - | - | - | - | - | - | - | 20 |
| C ex 44 | - | - | - | 0.10 | - | - | - | - | - | 10 |
| C ex 45 | - | - | - | - | 0.10 | | - | - | - | 20 |
| C ex 46 | - | - | - | - | - | 0.10 | - | - | - | 10 |
| C ex 47 | - | - | - | - | - | - | 0.10 | - | - | 20 |
| C ex 48 | - | - | - | - | - | - | - | - | 0.10 | 8 |
| C ex 49 | 0.05 | - | - | - | - | - | - | - | - | 10 |
| C ex 50 | - | 0.40 | - | - | - | - | - | - | - | 10 |
| C ex 51 | - | - | - | 0.03 | - | - | - | - | - | 20 |
| C ex 52 | - | - | - | - | - | 0.60 | - | - | - | 20 |
| C ex 53 | - | - | - | - | - | - | 0.03 | - | - | 20 |
| C ex 54 | 3.00 | 0.10 | 0.50 | - | - | - | - | - | - | 15 |

| | | | | | | | | | | |
|---|---|---|---|---|---|---|---|---|---|---|
| Note:* The balance was Cu and unavoidable impurities, and "-" means not added. | | | | | | | | | | |

**Table 3-2**

| | Cold-working 1 | | Heating 1 | | | Cold-working 2 | | Heating 2 | | |
|---|---|---|---|---|---|---|---|---|---|---|
| | Φ | Working degree | Manner | Heating temp. | Heating time | Φ or t×w | Working degree | Manner | Heating temp. | Heating time |
| | mm | | | °C | | mm | | | °C | |
| Ex 75 | 2.60 | 2.7 | Batch | 420 | 1 hr | 0.70 | 2.6 | Batch | 430 | 1 hr |
| Ex 76 | 8.00 | 2.0 | Batch | 430 | 30 min | 2.60 | 2.2 | Batch | 420 | 30 min |
| Ex 77 | 2.60 | 3.6 | Batch | 430 | 1 hr | 0.40 | 3.7 | Batch | 440 | 1 hr |
| Ex 78 | 2.00 | 3.2 | Batch | 520 | 30 min | 0.50 | 2.8 | Batch | 800 | 30 min |
| Ex 79 | 2.60 | 2.7 | Running | 700 | 0.5 sec | 0.90 | 2.1 | Running | 700 | 0.5 sec |
| Ex 80 | 2.60 | 2.7 | Running | 500 | 1 sec | 0.60 | 2.9 | Running | 500 | 1 sec |
| Ex 81 | 2.60 | 3.1 | Running | 420 | 1 sec | 0.60 | 2.9 | Running | 420 | 1 sec |
| Ex 82 | 2.00 | 3.2 | Running | 500 | 1 sec | 0.60 | 2.4 | Batch | 420 | 2 hr |
| Ex 83 | 2.00 | 3.2 | Electric | 480 | 1 sec | 0.50 | 2.8 | Batch | 400 | 1 hr |
| Ex 84 | 8.00 | 2.0 | Batch | 400 | 1 hr | 2.60 | 2.2 | Running | 530 | 4 sec |
| Ex 85 | 2.60 | 2.7 | Electric | 520 | 0.5 sec | 0.50 | 3.3 | Running | 530 | 0.5 sec |
| C ex 41 | 1.20 | 4.2 | Running | 550 | 1 sec | 0.15 | 4.2 | Running | 550 | 1 sec |
| C ex 42 | 2.60 | 4.1 | Batch | 550 | 1 hr | 1.00 | 1.9 | Running | 680 | 1 sec |
| C ex 43 | 2.00 | 4.6 | Running | 550 | 1 sec | 0.50 | 2.8 | Running | 520 | 1 sec |
| C ex 44 | 2.60 | 2.7 | Running | 520 | 1 sec | 0.70 | 2.6 | Running | 250 | 1 sec |
| C ex 45 | 1.50 | 5.2 | Batch | 400 | 2 hr | 1.00 | 0.8 | Batch | 420 | 2 hr |
| C ex 46 | 6.00 | 1.0 | Batch | 430 | 30 min | 0.15 | 7.4 | Batch | 450 | 30 min |
| C ex 47 | 6.00 | 2.4 | Electric | 600 | 2 sec | 0.45 | 5.2 | Batch | 400 | 30 min |
| C ex 48 | 1.50 | 3.3 | Running | 250 | 1 sec | 0.50 | 2.2 | Batch | 400 | 1 hr |
| C ex 49 | 2.00 | 3.2 | Batch | 480 | 1 hr | 0.50 | 2.8 | Running | 570 | 2 sec |
| C ex 50 | 2.60 | 2.7 | Running | 480 | 1 sec | 0.70 | 2.6 | Batch | 400 | 1 hr |
| C ex 51 | 1.00 | 6.0 | Running | 480 | 1 sec | 0.50 | 1.4 | Electric | 500 | 0.3 sec |
| C ex 52 | 2.00 | 4.6 | Batch | 430 | 30 min | 1.30 | 0.9 | Running | 500 | 0.5 sec |
| C ex 53 | 8.00 | 1.8 | Running | 480 | 1 sec | 2.00 | 2.8 | Electric | 480 | 1 sec |
| C ex 54 | 2.20 | 3.8 | Running | 700 | 1 sec | 0.35 | 3.7 | Batch | 530 | 1 hr |

**Table 3-3**

| | Cold-working 3 | | Heating 3 | | | Cold-working 4 Heating 4 | | | | |
|---|---|---|---|---|---|---|---|---|---|---|
| | Φ or t×w | Working degree | Manner | Heating temp. | Heating time | Φ or t×w Working degree | | Manner | Heating temp. | Heating time |
| | mm | | | °C | | mm | | | °C | |
| Ex 75 | 0.10×1.80 | 2.0 | Batch | 450 | 1 hr | - | | | | |
| Ex 76 | 0.50 | 3.3 | Batch | 430 | 30 min | 0.20 | 1.8 | Batch | 430 | 30 min |
| Ex 77 | 0.10 | 2.8 | Batch | 440 | 1 hr | 0.04×0.07 | 0.9 | Batch | 450 | 1 hr |
| Ex 78 | 0.06×1.00 | 2.1 | Batch | 550 | 30 min | - | | | | |
| Ex 79 | 0.30 | 2.2 | Batch | 550 | 1 hr | 0.08×0.35 | 1.3 | Running | 750 | 0.5 sec |
| Ex 80 | 0.06×2.00 | 2.6 | Running | 500 | 1 sec | - | | | | |
| Ex 81 | 0.20 | 2.2 | Running | 420 | 1 sec | 0.04×0.15 | 1.6 | Running | 500 | 1 see |
| Ex 82 | 0.07×1.00 | 2.1 | Batch | 400 | 2 hr | - | | | | |
| Ex 83 | 0.05×1.00 | 2.3 | Running | 550 | 1 sec | - | | | | |
| Ex 84 | 1.00 | 1.9 | Batch | 420 | 1 hr | 0.20 | 3.2 | Running | 520 | 4 sec |
| Ex 85 | 0.15 | 2.4 | Electric | 540 | 0.5 sec | 0.03×0.10 | 1.6 | Electric | 530 | 0.5 sec |
| C ex 41 | 0.03×0.15 | 1.6 | Running | 650 | 1 sec | - | | | | |
| C ex 42 | 0.50 | 1.4 | Running | 680 | 1 sec | 0.06x0.40 | 2.1 | Batch | 570 | 1 hr |
| C ex 43 | 0.03×0.10 | 2.8 | Electric | 550 | 2 sec | - | | | | |
| C ex 44 | 0.07×0.20 | 2.3 | Electric | 550 | 1 sec | - | | | | |
| C ex 45 | 0.30 | 2.4 | Electric | 530 | 0.6 sec | 0.03×0.10 | 2.3 | Batch | 420 | 30 min |
| C ex 46 | 0.03×0.10 | 1.6 | Batch | 650 | 2 hr | - | | | | |
| C ex 47 | 0.03×0.80 | 2.7 | Electric | 560 | 0.2 sec | - | | | | |
| C ex 48 | 0.06×1.50 | 2.1 | Running | 550 | 1 sec | - | | | | |
| C ex 49 | 0.20 | 1.8 | Batch | 480 | 1 hr | 0.15 | 0.6 | Electric | 570 | 1 sec |
| C ex 50 | 0.08×0.45 | 2.2 | Running | 580 | 1 sec | - | | | | |
| C ex 51 | 0.15 | 2.4 | Batch | 430 | 30 min | 0.05×0.40 | 1.1 | Running | 450 | 0.5 sec |
| C ex 52 | 0.10×1.50 | 2.6 | Running | 480 | 1 sec | - | | | | |
| C ex 53 | 0.40 | 3.2 | Batch | 430 | 1 hr | 0.08×0.35 | 1.6 | Batch | 450 | 1 hr |
| C ex 54 | 0.15 | 1.7 | Running | 700 | 1 sec | 0.03×0.10 | 1.6 | Batch | 650 | 2 hr |

**Table 3-4**

| | Cold-working 5 | | Heating 5 | | | Working degree in final working | Grain size |
|---|---|---|---|---|---|---|---|
| | Φ or t×w | Working degree | Manner | Heating temp. | Heating time | | |
| | mm | | | °C | | | µm |
| Ex 75 | - | | | | | 2.0 | 0.10 |
| Ex 76 | 0.02×0.30 | 2.3 | Batch | 450 | 30 min | 2.3 | 0.30 |
| Ex 77 | - | | | | | 0.9 | 1.20 |
| Ex 78 | - | | | | | 2.1 | 0.10 |
| Ex 79 | - | | | | | 1.3 | 1.10 |
| Ex 80 | - | | | | | 2.6 | 0.10 |
| Ex 81 | - | | | | | 1.6 | 0.30 |
| Ex 82 | - | | | | | 2.1 | 0.10 |
| Ex 83 | - | | | | | 2.3 | 0.10 |
| Ex 84 | 0.05×0.20 | 1.4 | Running | 650 | 4 sec | 1.4 | 1.20 |
| Ex 85 | - | | | | | 1.6 | 0.70 |
| C ex 41 | - | | | | | 1.6 | 0.50 |
| C ex 42 | - | | | | | 2.1 | 1.00 |
| C ex 43 | - | | | | | 2.8 | 12.00 |
| C ex 44 | - | | | | | 2.3 | 0.50 |
| C ex 45 | - | | | | | 2.3 | 0.30 |
| C ex 46 | - | | | | | 1.6 | 1.50 |
| C ex 47 | - | | | | | 2.7 | 10.00 |
| C ex 48 | - | | | | | 2.1 | 2.20 |
| C ex 49 | 0.04×0.20 | 1.3 | Batch | 450 | 30 min | 1.3 | 1.10 |
| C ex 50 | - | | | | | 2.2 | 0.10 |
| C ex 51 | - | | | | | 1.1 | 1.50 |
| C ex 52 | - | | | | | 2.6 | 0.10 |
| C ex 53 | - | | | | | 1.6 | 2.20 |
| C ex 54 | - | | | | | 1.6 | 1.80 |

**Table 3-5**

| | <101> area ratio | <111> area ratio | <101> area ratio | Characteristics | | | | | |
|---|---|---|---|---|---|---|---|---|---|
| | | | | EI after heating | TS after heating | EC | Coil service life | Coil formability | Comprehensive evaluation |
| | % | % | % | % | MPa | %IACS | | | |
| Ex 75 | 23 | 55 | 13 | 36 | 305 | 100 | A | A | A |
| Ex 76 | 15 | 42 | 15 | 32 | 302 | 98 | A | B | A |
| Ex 77 | 25 | 15 | 25 | 36 | 308 | 94 | A | A | A |
| Ex 78 | 12 | 38 | 12 | 31 | 315 | 91 | A | B | A |
| Ex 79 | 26 | 25 | 26 | 37 | 323 | 88 | A | A | A |
| Ex 80 | 11 | 45 | 11 | 32 | 285 | 75 | B | B | B |
| Ex 81 | 23 | 25 | 23 | 38 | 287 | 77 | B | A | A |
| Ex 82 | 14 | 43 | 14 | 31 | 279 | 93 | B | B | B |
| Ex 83 | 15 | 45 | 15 | 32 | 286 | 95 | B | B | B |
| Ex 84 | 23 | 28 | 17 | 36 | 287 | 90 | B | A | A |
| Ex 85 | 25 | 35 | 16 | 37 | 269 | 89 | B | A | A |
| C ex 41 | 4 | 64 | 4 | 17 | 302 | 96 | A | D | D |
| C ex 42 | 5 | 69 | 5 | 18 | 313 | 91 | A | D | D |
| C ex 43 | 3 | 73 | 3 | 16 | 278 | 90 | B | D | D |
| C ex 44 | 2 | 69 | 2 | 16 | 285 | 90 | B | D | D |
| C ex 45 | 1 | 63 | 1 | 18 | 278 | 98 | B | D | D |
| C ex 46 | 3 | 69 | 3 | 19 | 269 | 93 | B | D | D |
| C ex 47 C ex 48 C ex 49 | 1 | 72 | 1 | 15 | 284 | 95 | B | D | D |
| | 2 | 67 | 2 | 16 | 279 | 89 | B | D | D |
| | 21 | 25 | 21 | 36 | 246 | 100 | D | A | D |
| C ex 50 | 14 | 49 | 14 | 32 | 287 | 67 | B | B | D |
| C ex 51 | 23 | 63 | 23 | 18 | 250 | 96 | D | D | D |
| C ex 52 | 3 | 73 | 3 | 17 | 285 | 68 | B | D | D |
| C ex 53 | 14 | 33 | 14 | 32 | 245 | 99 | D | B | D |
| C ex 54 | 11 | 40 | 11 | 33 | 312 | 60 | A | B | D |

From Tables 3-1 to 3-5, it is found that even in the case of the rectangular wires, the similar results as in the case of the round wires presented in Tables 1-1 to 1-3 and Tables 2-1 to 2-15 were obtained.

Examples according to this invention and Comparative examples regarding the round wires when round wires made of a Cu-2% Ag alloy were produced up to a final wire diameter of φ0.05 mm to 0.2 mm, are presented in Tables 4-1 to 4-3.

**Table 4-1**

| | Composition* | Ingot diameter | Cold-working 1 | | Heating 1 | | |
|---|---|---|---|---|---|---|---|
| | Ag | | Wire diameter | Working degree | Manner | Heating temp. | Heating time |
| | mass% | mm | mm | | | °C | |
| Ex 92 | 2.00 | 10 | 2.60 | 2.7 | Running | 650 | 1 sec |
| Ex 93 | 2.00 | 10 | 2.60 | 2.7 | Running | 650 | 1 sec |
| Ex 94 | 2.00 | 10 | 2.60 | 2.7 | Running | 650 | 1 sec |
| Ex 95 | 2.00 | 10 | 1.60 | 3.7 | Running | 650 | 1 sec |
| C ex 55 | 2.00 | 10 | 3.00 | 2.4 | Running | 650 | 1 sec |
| C ex 56 | 2.00 | 10 | 2.20 | 3.0 | Running | 650 | 1 sec |
| C ex 57 | 2.00 | 10 | 1.50 | 3.8 | Running | 650 | 1 sec |
| C ex 58 | 2.00 | 10 | 0.75 | 5.2 | Running | 650 | 1 sec |

| | | | | | | | |
|---|---|---|---|---|---|---|---|
| Note: * The balance was Cu and unavoidable impurities, and "-" means not added. | | | | | | | |

**Table 4-2**

| | Cold-working 2 | | Heating 2 | | | Cold-working 3 | | Heating 3 | | |
|---|---|---|---|---|---|---|---|---|---|---|
| | Wire diameter | Working degree | Manner | Heating temp. | Heating time | Wire diameter | Working degree | Manner | Heating temp. | Heating time |
| | mm | | | °C | | mm | | | °C | |
| Ex 92 | 1.00 | 1.9 | Running | 650 | 1 sec | 0.20 | 3.2 | Running | 650 | 1 sec |
| Ex 93 | 0.75 | 2.5 | Running | 650 | 1 sec | 0.15 | 3.2 | Running | 650 | 1 sec |
| Ex 94 | 0.50 | 3.3 | Running | 650 | 1 sec | 0.10 | 3.2 | Running | 650 | 1 sec |
| Ex 95 | 0.25 | 3.7 | Running | 650 | 1 sec | 0.05 | 3.2 | Running | 650 | 1 sec |
| C ex 55 | 0.20 | 5.4 | Running | 650 | 1 sec | - | | | | |
| C ex 56 | 0.15 | 5.4 | Running | 650 | 1 sec | - | | | | |
| C ex 57 | 0.10 | 5.4 | Running | 650 | 1 sec | - | | | | |
| C ex 58 | 0.05 | 5.4 | Running | 650 | 1 sec | - | | | | |

**Table 4-3**

| | Grain size | <101> area ratio | <100> area ratio | <111> area ratio | Characteristics | | | | | |
|---|---|---|---|---|---|---|---|---|---|---|
| | | | | | EI after heating | TS after heating | EC | Coil service life | Coil formability | Comprehensive evaluation |
| | µm | % | % | % | % | MPa | %IACS | | | |
| Ex 92 | 0.90 | 15 | 58 | 20 | 31 | 316 | 91 | A | B | A |
| Ex 93 | 1.10 | 12 | 56 | 19 | 32 | 314 | 92 | A | B | A |
| Ex 94 | 0.60 | 13 | 57 | 13 | 31 | 318 | 92 | A | B | A |
| Ex 95 | 0.60 | 11 | 55 | 22 | 34 | 312 | 91 | A | B | A |
| C ex 55 | 0.20 | 3 | 22 | 62 | 19 | 315 | 90 | B | D | D |
| C ex 56 | 0.15 | 3 | 23 | 61 | 16 | 314 | 91 | B | D | D |
| C ex 57 | 0.15 | 4 | 22 | 60 | 18 | 318 | 91 | B | D | D |
| C ex 58 | 0.10 | 1 | 21 | 61 | 17 | 312 | 92 | B | D | D |

The bending test was performed in such a manner that the bending radius R was fixed to 1 mm such that the bending strain became constant in any of wire diameters. With respect to Comparative examples, even in copper alloy round wires having any of wire diameters, Examples according to this invention exhibited characteristics, in which the elongation was excellent, and in which coil characteristics were also excellent. In particular, in the case of a copper alloy round wire having a fine wire diameter, it is found that a difference in performance between Examples according to this invention and Comparative examples is noticeable, and that the present invention is extremely effective for an extra-fine wire.

Also in the case of the rectangular wires, the similar results as in the case of the round wires are obtained.

## Claims

1. A copper alloy wire consisting of at least one selected from the group consisting of:
[1] 0.1 to 4 mass% of Ag; and
[2] at least one selected from the group consisting of Sn, Mg, Zn, In, Ni, Co, Zr and Cr each at a content of 0.05 to 0.30 mass%,
with the balance being Cu and unavoidable impurities,
wherein
the copper alloy wire has a recrystallized texture, a tensile strength of 260 MPa or more, and an elongation of 30% or more;
the wire diameter or wire thickness is 0.1 mm or less and 0.01 mm or more;
the area ratio of grains having <101> orientation, when a cross-section perpendicular to the longitudinal direction of the wire is observed by EBSD in a direction normal to the cross-section, is 10% or more of the entire measurement area, , wherein the area ratio of the grains having <101> orientation is obtained by an EBSD method in such a manner that the cross-section perpendicular to the longitudinal direction (transverse cross-section) of a copper alloy wire sample is scanned at a step of 0.02 µm; the orientation of each grain is observed and analyzed; based on the analyzed results, a plane in which a deviation angle with the <101> orientation is within ±10 degrees is defined as a <101> plane; a grain which has a plane in which a deviation angle with the <101> orientation is within ±10 degrees when the cross-section perpendicular to the longitudinal direction of the wire is observed by EBSD in a direction normal to the cross-section, is defined as a grain having the <101> orientation; the area ratio (%) of grains having the <101> orientation with respect to the entire measurement area is calculated based on the measurement results.

2. The copper alloy wire according to claim 1, wherein the area ratio of the grains having <101> orientation is 20% or more of the entire measurement area.

3. The copper alloy wire according to claim 1 or 2, wherein the average grain size of the matrix is 0.2 to 5.0 µm.

4. A method of producing the copper alloy wire according to any one of claims 1 to 3, the method including the steps of:
melting and casting a copper alloy material giving an alloy composition, which consists of at least one selected from the group consisting of:
[1] 0.1 to 4.0 mass% of Ag, and
[2] at least one selected from the group consisting of Sn, Mg, Zn, In, Ni, Co, Zr and Cr each at a content of 0.05 to 0.30 mass%,
with the balance being Cu and unavoidable impurities, to thereby obtain a roughly-drawn rod;
repeating cold-working in which a working degree η in each cold-working step is 0.5 or more but 4 or less and intermediate annealing each at least one time in this order on the roughly-drawn rod, to obtain a wire having a predetermined wire diameter; and then
performing final cold-working in which a working degree η is 0.5 or more but 4 or less and final-annealing on the wire in this order,
in which, when a batch-type intermediate annealing or a batch-type final-annealing is performed, heating is performed at: (i) 300 to 800°C; or (ii) 400 to 800°C when Ag or Zr is contained as an element; but each equal to or higher than the recrystallizing temperature of the copper alloy material, for 30 minutes to 2 hours under an inert gas atmosphere; or
when a continuous-type intermediate annealing or a continuous-type final-annealing is performed, heating is performed at: (i) 400 to 850°C; or (ii) 500 to 850°C when Ag or Zr is contained as an element; but each equal to or higher than the recrystallizing temperature of the copper alloy material, for 0.1 to 5 seconds under an inert gas atmosphere.

## Patentansprüche

1. Draht aus Kupferlegierung, der aus mindestens einem besteht, das aus der Gruppe ausgewählt ist, die besteht aus:
[1] 0,1 bis 4 Masse-% Ag; und
[2] mindestens einem, das aus der Gruppe ausgewählt ist, die aus Sn, Mg, Zn, In, Ni, Co, Zr und Cr jeweils mit einem Gehalt von 0,05 bis 0,30 Masse-% besteht,
wobei der Rest aus Cu und unvermeidlichen Verunreinigungen besteht, wobei der Draht aus Kupferlegierung eine rekristallisierte Textur, eine Zugfestigkeit von 260 MPa oder mehr und eine Längung von 30% oder mehr aufweist;
der Drahtdurchmesser oder die Drahtdicke 0,1 mm oder weniger und 0,01 mm oder mehr beträgt;
das Flächenverhältnis von Körnern mit einer <101>-Orientierung, wenn ein Querschnitt senkrecht zur Längsrichtung des Drahts durch EBSD in einer Richtung normal zum Querschnitt beobachtet wird, 10% oder mehr der gesamten Messfläche beträgt, wobei das Flächenverhältnis der Körner mit einer <101>-Orientierung durch ein EBSD-Verfahren in einer solchen Weise erhalten wird, dass der Querschnitt senkrecht zur Längsrichtung (transversaler Querschnitt) einer Drahtprobe aus Kupferlegierung mit einem Schritt von 0,02 µm abgetastet wird; die Orientierung jedes Korns beobachtet und analysiert wird; beruhend auf den Analyseergebnissen eine Ebene, in der ein Abweichungswinkel von der <101>-Orientierung innerhalb von ±10 Grad liegt, als eine <101> Ebene definiert wird; ein Korn, das eine Ebene aufweist, in der ein Abweichungswinkel von der <101>-Orientierung innerhalb von ± 10 Grad liegt, wenn der Querschnitt senkrecht zur Längsrichtung des Drahts durch EBSD in einer Richtung normal zum Querschnitt beobachtet wird, als ein Korn mit der <101>-Orientierung definiert wird; das Flächenverhältnis (%) der Körner mit der <101>-Orientierung bezüglich der gesamten Messfläche beruhend auf den Messergebnissen berechnet wird.

2. Draht aus Kupferlegierung nach Anspruch 1, wobei das Flächenverhältnis der Körner mit einer <101>-Orientierung 20% oder mehr der gesamten Messfläche beträgt.

3. Draht aus Kupferlegierung nach Anspruch 1 oder 2, wobei die durchschnittliche Korngröße der Matrix 0,2 bis 5,0 µm beträgt.

4. Verfahren zum Herstellen des Drahts aus Kupferlegierung nach einem der Ansprüche 1 bis 3, wobei das Verfahren die Schritte aufweist:
Schmelzen und Gießen eines Kupferlegierungsmaterials, das eine Legierungszusammensetzung ergibt, die aus mindestens einem besteht, das aus der Gruppe ausgewählt ist, die besteht aus:
[1] 0,1 bis 4.0 Masse-% Ag, und
[2] mindestens einem, das aus der Gruppe ausgewählt ist, die aus Sn, Mg, Zn, In, Ni, Co, Zr und Cr jeweils mit einem Gehalt von 0,05 bis 0,30 Masse-% besteht,
wobei der Rest aus Cu und unvermeidlichen Verunreinigungen besteht, um dadurch einen grob gezogenen Stab zu erhalten;
Wiederholen einer Kaltverformung, in der ein Verformungsgrad η in jedem Kaltverformungsschritt 0,5 oder mehr, jedoch 4 oder weniger beträgt, und von Zwischenglühen jeweils mindestens einmal in dieser Reihenfolge am grob gezogenen Stab, um einen Draht mit einem vorgegebenen Drahtdurchmesser zu erhalten; und dann Durchführen einer endgültigen Kaltverformung, in der ein Verformungsgrad η 0,5 oder
mehr, jedoch 4 oder weniger beträgt und Endglühen am Draht in dieser Reihenfolge, wobei, wenn ein Chargen-Zwischenglühen oder ein Chargen-Endglühen durchgeführt wird, die Erwärmung durchgeführt wird bei: (i) 300 bis 800°C; oder (ii) 400 bis 800°C,
wenn Ag oder Zr als ein Element enthalten ist; jedoch gleich oder höher als die Rekristallisationstemperatur des Kupferlegierungsmaterials, für 30 Minuten bis 2 Stunden unter einer Inertgasatmosphäre; oder
wenn ein kontinuierliches Zwischenglühen oder ein kontinuierliches Endglühen durchgeführt wird, die Erwärmung durchgeführt wird bei: (i) 400 bis 850°C; oder (ii) 500 bis 850°C wenn Ag oder Zr als ein Element enthalten ist; jedoch gleich oder höher als die Rekristallisationstemperatur des Kupferlegierungsmaterials, für 0,1 bis 5 Sekunden unter einer Inertgasatmosphäre.

## Revendications

1. Fil d'alliage de cuivre, comprenant :
[1] 0,1 à 4 % en masse d'Ag; et
[2] au moins un élément choisi dans le groupe constitué de Sn, Mg, Zn, In, Ni, Co, Zr et Cr, avec une teneur comprise entre 0,05 et 0,30 % en masse chacun,
le reste étant du Cu et des impuretés inévitables, où
ledit fil d'alliage de cuivre a une texture recristallisée, une résistance à la traction égale ou supérieure à 260 MPa, et une élongation égale ou supérieure à 30 % ;
le diamètre ou l'épaisseur du fil sont compris entre 0,01 mm et 0,1 mm ;
le rapport surfacique des grains ayant une orientation <101>, si une section perpendiculaire au sens de la longueur du fil est observée par EBSD dans une direction normale à la section transversale, est égale ou supérieure à 10 % de toute l'aire de mesure, ledit rapport surfacique des grains ayant une orientation <101> étant obtenu par procédé EBSD de telle manière que la section perpendiculaire au sens de la longueur (section transversale) d'un échantillon de fil d'alliage de cuivre est balayée par pas de 0,02 µm ; l'orientation de chaque grain est observée et analysée ; sur la base des résultats d'analyse, un plan où un angle de déviation avec l'orientation <101> est compris entre ±10 degrés est défini en tant que plan <101> ; un grain ayant un plan où un angle de déviation avec l'orientation <101> est compris entre ±10 degrés si la section perpendiculaire au sens de la longueur du fil est observée par EBSD dans une direction normale à la section transversale, est défini en tant que grain ayant l'orientation <101> ; le rapport surfacique (%) des grains ayant l'orientation <101> par rapport à toute l'aire de mesure est calculé sur la base des résultats de mesure.

2. Fil d'alliage de cuivre selon la revendication 1, où le rapport surfacique des grains ayant l'orientation <101> est égal ou supérieur à 20 % de toute l'aire de mesure.

3. Fil d'alliage de cuivre selon la revendication 1 ou la revendication 2, où la granulométrie moyenne de la matrice est comprise entre 0,2 et 5,0 µm.

4. Procédé de fabrication du fil d'alliage de cuivre selon l'une des revendications 1 à 3, ledit procédé comprenant les étapes suivantes :
fonte et coulée d'un matériau d'alliage de cuivre donnant une composition d'alliage, comprenant :
[1] 0,1 à 4 % en masse d'Ag ; et
[2] au moins un élément choisi dans le groupe constitué de Sn, Mg, Zn, In, Ni, Co, Zr et Cr, avec une teneur comprise entre 0,05 et 0,30 % en masse chacun,
le reste étant du Cu et des impuretés inévitables, afin d'obtenir une tige brute étirée ;
répétition de l'écrouissage où un degré de formage η de chaque phase d'écrouissage est compris entre 0,5 et 4 et recuit intermédiaire de la tige brute étirée au moins une fois dans cet ordre, pour obtenir un fil de diamètre défini ; puis
écrouissage final où un degré de formage η est compris entre 0,5 et 4, et recuit final du fil dans cet ordre,
où, si un recuit intermédiaire de type discontinu ou un recuit final de type discontinu sont exécutés, un chauffage est effectué : (i) entre 300 et 800 °C ; ou (ii) entre 400 et 800 °C si Ag ou Zr sont contenus en tant qu'élément ; toutefois à une température égale ou supérieure pour chacun à la température de recristallisation du matériau d'alliage de cuivre, pendant 30 minutes à 2 heures dans une atmosphère de gaz inerte ; ou,
si un recuit intermédiaire de type continu ou un recuit final de type continu sont exécutés, un chauffage est effectué : (i) entre 400 et 850 °C ; ou (ii) entre 500 et 850 °C si Ag ou Zr sont contenus en tant qu'élément ; toutefois à une température égale ou supérieure pour chacun à la température de recristallisation du matériau d'alliage de cuivre, pendant 0,1 à 5 secondes dans une atmosphère de gaz inerte.
